# EUROPÄISCHE PATENTSCHRIFT

(11) **EP 3 939 850 B1**
(45) Veröffentlichungstag und Bekanntmachung des Hinweises auf die Patenterteilung: **13.12.2023**
(21) Anmeldenummer: 21185541.6
(22) Anmeldetag: 14.07.2021
(51) Int. Cl.: B61D 17/04, B61D 17/08, B64C 1/06, B63B 3/28

(54) **VERSTEIFUNGSSTRUKTUR UND VERFAHREN FÜR DIE VERSTEIFUNG EINES FLÄCHENELEMENTES**
REINFORCEMENT STRUCTURE AND METHOD FOR REINFORCING AN ELEMENT
STRUCTURE DE RENFORT ET PROCÉDÉ DE RENFORT D'UN ÉLÉMENT PLAT

(30) Priorität: 14.07.2020 EP 20185657; 01.10.2020 EP 20199587
(43) Veröffentlichungstag der Anmeldung: 19.01.2022
(73) Patentinhaber: Photon AG, 13581 Berlin (DE)
(72) Erfinder: Dziekan, Thomas, 14053 Berlin (DE); Elliesen, Uriel, 14532 Stahnsdorf (DE); Knaub, Andreas, 13593 Berlin (DE); Braun, Robert, 10247 Berlin (DE); Neumann, Lukas, 12045 Berlin (DE); Alder, Holger, 13591 Berlin (DE)
(74) Vertreter: Hertin und Partner Rechts- und Patentanwälte PartG mbB

(56) Entgegenhaltungen:
- EP-A1- 2 628 677
- DE-C- 691 524
- JP-A- 2008 189 265
- US-A- 2 389 767

## Beschreibung

Die Erfindung betrifft bevorzugt ein Verfahren für die Versteifung eines Flächenelementes.

Das Verfahren umfasst dabei einen ersten Schritt, indem Versteifungsmodule bereitgestellt werden, die einen Gurt und mind. einen Steg umfassen. Weiterhin werden die Versteifungsmodule entlang eines Lastpfades an dem Flächenelement aneinandergereiht angebracht, wobei die Versteifungsmodule über Verbindungsmittel und/oder Fügeverfahren formschlüssig, kraftschlüssig und/oder stoffschlüssig an den jeweiligen Gurten miteinander zu einer Versteifungsstruktur verbunden werden, sodass die Versteifungsmodule eine gemeinsame Wirkung, nämlich die Versteifung und Verstärkung des Flächenelementes, entfalten.

In Bezug auf das Flächenelement wird mindestens ein topologieoptimierter Lastpfad auf Basis von belastungsoptimierten Berechnungen und/oder Simulationen bestimmt, welcher nicht geradlinig verläuft. Anschließend erfolgt eine Konstruktion eines Versteifungsmodules entlang des Lastpfades, welches in modulare Einheiten sequenziert wird. Aufgrund der erhaltenen Sequenzen können die Versteifungsmodule gefertigt werden, wobei vorteilhaft konventionelle Fertigungsmethoden einsetzbar sind.

Die Erfindung betrifft zudem ein Versteifungssystem mit den technischen Merkmalen des Anspruchs 9.

### Hintergrund und Stand der Technik

Konstruktive Versteifungen werden gezielt in Bauteile eingebracht, um die Steifigkeit einer Leichtbaukonstruktion zu erhöhen. Ziel dieser Versteifungen ist es, dem Bauteil bei konstantem Eigengewicht eine höhere Tragfähigkeit zu verleihen.

Versteifungsstrukturen auf flächigen Strukturen werden im Stand der Technik in nahezu allen Anwendungen und Industrien mittels "Rippen/Steifen/Spanten" (engl.: "Stringern") realisiert. Diese "Rippen" werden aufgrund der historisch gewachsenen einfachen und kostengünstigen Herstellung zum größten Teil aus linearen Profilen realisiert.

In den meisten Anwendungsfällen hat sich aufgrund der leichten Verfügbarkeit der Profile die "lineare" Bauweise für Großstrukturen, z.B. im Tragwerksbau und insbesondere beim Bau von Fahrzeugrümpfen durchgesetzt (Schienenfahrzeugbau, Flugzeugbau, Schiffbau, Nutzfahrzeuge, etc.)

Aufgrund der durch die Bausysteme beeinflussten möglichen Konstruktionen sind diese Rippen jeweils auf eine lokale maximale Belastung ausgelegt und dadurch in anderen Bereichen gegenüber der Notwendigkeit überdimensioniert. Diese Überdimensionierung verbraucht erstens unnötiges Material (Ressourcen) und erhöht zweitens das Gewicht der Konstruktion, womit auch der Energiebedarf zur Fortbewegung und damit der CO2-Verbrauch der Fahrzeuge erhöht wird.

Dank der aktuellen Rechen- und Maschinen-Systemen werden heute allerdings auch "nicht-lineare", belastungsoptimierte und damit auch gewichtsoptimierte Konstruktionsberechnungen und Simulationen möglich [1].

Diese "topologieoptimierten" oder auch "bionischen" (also der Evolution nachempfundenen) Konstruktionen scheiternden allerdings bisher an den fehlenden Herstellungsmöglichkeiten.

Die aktuell verfügbaren 3D-Druck-Prozesse sind nicht in der Lage, Großstrukturen wie das Bionic Aircraft (Bionic Aircraft ist ein von der EU gefördertes Forschungsprojekt, welches anhand bionischer Designs die Verbesserung der Ressourceneffizienz in der Luftfahrt zum Ziel hat.) oder ähnliche Rumpfelemente für andere Fahrzeugarten zu fertigen.

Für die Herstellung bionischer Strukturen ist "3D-Drucken" eine populär verfolgte Möglichkeit. Die aktuell verfügbare sehr geringe Aufbaurate und andere technologische Nachteile beschränken deren Anwendung auf Bauteile mit maximal einem Meter Kantenlänge. Hochleistungs-3D-Druck-Verfahren erreichen zurzeit Aufbauraten von maximal 10 kg Material pro Stunde. Filigrane bionische Strukturen lassen sich mit diesen nicht realisieren. Der durch hohen Energieeintrag erzeugte Verzug macht die Rohbaustruktur nicht verwendbar.

Eine lineare Profilkonstruktion einer aktuellen Zugseitenwand, insbesondere ICE4-Seitenwand, wiegt 105 Kilogramm und ist 20% schwerer als die notwendige bionische Struktur. Allerdings wird diese in mehreren manuellen Schritten in nur 4,8 Stunden auf dem Außenhautblech aufgebaut, teilautomatisiert, verzugs- und nacharbeitsarm lasergeschweißt. Mit diesem Fertigungsverfahren aus vertikalen und horizontalen Versteifungen lassen sich mit 22 kg Material pro Stunde höhere "Aufbauraten" als mit einem 3D-Druckverfahren erreichen.

Nach bionischen Prinzipien topologieoptimierte Strukturen können aufgrund ihrer komplexen Formen nicht mit konventionellen Herstellungsverfahren produziert werden. Der Stand der Technik erlaubt lineare Strukturen, die ein Tragwerk aus vertikalen Säulen und horizontalen Trägern abbilden. Mit größer werdenden Einzelelementen wird die Vorproduktion der Einzelteile aufwendiger. Additive Fertigungsverfahren eignen sich zwar gut für komplexe 3D-Formen, großvolumiger 3D-Druck ist jedoch auf absehbare Zeit nicht marktreif. Die Auftragsraten sind zu gering, der prozessbedingte Bauteilverzug zu hoch und es mangelt an Prozesssicherheit.

Darüber hinaus sind aus dem Stand der Technik Versteifungsstrukturen für Flächenelemente bekannt, die geeignet sind, um Gewichtseinsparungen zu erzielen, wobei diese Versteifungsstrukturen jedoch die bereits erörterte nachteilige lineare Bauform aufweisen.

Die JP 2008 189265 A offenbart zum Beispiel eine Versteifungsstruktur, welche in einer (Schienen-) Fahrzeugkarosserie integriert ist. Die Versteifungsstruktur ist aus einer Vielzahl von Bauteilen zusammengesetzt. Insbesondere weist die Versteifungsstruktur zwei vertikale Versteifungsmodule auf, wobei diese von einem quer zu diesen Versteifungsmodulen verlaufenden Träger unterbrochen werden. Die beiden in der offenbarten Versteifungsstruktur umfassten Versteifungsmodule weisen jeweils einen Gurt sowie zwei Stege auf. Die Gurte sind dabei über eine Verbindungsplatte miteinander verbunden, welche den quer zu den Versteifungsmodulen verlaufenden Träger überbrückt.

Die EP 2 628 677 A1 betrifft eine Versteifungsstruktur für Flugzeuge. In einer offenbarten Ausführungsform weist die Versteifungsstruktur zwei Versteifungsmodule auf, die jeweils einen Gurt und zwei Stege umfassen und darüber hinaus miteinander über ein Koppelelement an den Stegen in Verbindung stehen.

Die DE 691 524 C offenbart eine Versteifungsstruktur für Wandungen von Schiffen. Die Versteifungsstruktur umfasst einen linear verlaufenden L-Profilstahlträger, an welchem entlang seiner Längsachse eine Vielzahl von Stegen in einem Abstand voneinander über Verbindungsmittel befestigt sind. Die Stege sind angewinkelt, wobei zwei hintereinander angeordnete Stege entgegengesetzt zueinander ausgerichtet sind.

Die US 2 389 767 A offenbart eine Versteifungsstruktur für Flugzeugkonstruktionen. Die Versteifungsstruktur weist einen linear verlaufenden Träger auf, welcher durch Stege und einem durchgängigen Gurt ausgestaltet ist. Die Stege umfassen Freiräume oder Aussparungen, um das Kreuzen von Versteifungsstrukturen zu vereinfachen. Eine "topologieoptimierte" oder auch "bionische" Konstruktion ist entsprechend mit diesen Versteifungsstrukturen nicht realisierbar.

### Aufgabe der Erfindung

Die Aufgabe der Erfindung war es die Nachteile des Standes der Technik zu beseitigen und ein Verfahren für die Herstellung von nicht geradlinigen Versteifungsstrukturen eines Flächenelementes bereitzustellen, welches insbesondere eine erhöhte Fertigungsgeschwindigkeit, einen reduzierten Ressourcenbedarf sowie keine Limitierung im Hinblick auf Bauteilgrößen aufweist. Ferner soll das Verfahren eine gewichts- und materialsparende Versteifung mit einem verminderten Verzug ermöglichen.

Darüber hinaus war es die Aufgabe der Erfindung ein Versteifungssystem umfassend eine Versteifungsstruktur und ein Flächenelement mit den durch das Verfahren einhergehenden Vorteilen bereitzustellen.

### Zusammenfassung der Erfindung

Gelöst wird die Aufgabe durch die Merkmale der unabhängigen Ansprüche. Vorteilhafte Ausgestaltungen der Erfindung sind in den abhängigen Ansprüchen beschrieben.

Die Erfindung betrifft ein Verfahren für die Versteifung eines Flächenelementes umfassend:
- Bereitstellung von Versteifungsmodulen umfassend einen Gurt und mindestens einen Steg
- aneinandergereihte Anbringung der Versteifungsmodule entlang eines Lastpfades an dem Flächenelement, wobei die Versteifungsmodule über Verbindungsmittel und/oder Fügeverfahren formschlüssig, kraftschlüssig und/oder stoffschlüssig an den jeweiligen Gurten miteinander zu einer Versteifungsstruktur verbunden werden, sodass die Versteifungsmodule eine gemeinsame Wirkung, nämlich die Versteifung und Verstärkung des Flächenelementes entlang des Lastpfades entfalten
wobei der Lastpfad für das Flächenelement topologieoptimiert anhand einer belastungsoptimierten Simulation und/oder Berechnung erhalten wurde und wobei der Lastpfad nicht geradlinig ist.

Das erfindungsgemäße Verfahren weist wesentliche Vorteile gegenüber dem Stand der Technik auf. Die Verwendung von bevorzugten Versteifungsmodulen als hintereinander angeordnete Einheiten ermöglicht es sämtliche Lastpfade, insbesondere auch nicht geradlinig verlaufende Lastpfade nachzubilden und zu verstärken. Dies ermöglicht vorteilhaft die Ausgestaltung bionischer Strukturen, wobei die Herstellung der Module auch mit konventionellen Verfahren möglich ist.

Darüber hinaus hat sich gezeigt, dass die formschlüssige, kraftschlüssige und/oder stoffschlüssige Verbindung der jeweiligen Gurte der verschiedenen Module untereinander sowie die unterbrochene Verbindung der Stegabschnitte der Module ausreicht, um eine erforderliche Versteifung und/oder Verstärkung der gesamten Versteifungsstruktur zu erlangen. Es war dabei nicht vorherzusehen, dass die Versteifungsstrukturen trotz eines Zusammenfügens aus unterschiedlichen Versteifungsstrukturen sowie einer unterbrochenen Anbindung der Stege zuverlässig hohen Belastungen standhalten. Im Stand der Technik war bislang stets vorgesehen Versteifungsstrukturen, beispielsweise einen Träger, aus einem Teil (bevorzugt monolithisch) zu verwenden. In einigen Varianten sind ferner auch Träger bekannt, die aus mehreren Einzelteilen zusammengesetzt sind, wobei jedoch die Träger aus dem Stand der Technik stets in ihrer Gesamtheit bevorzugt als durchgängige Einheit sind, welche keine regelmäßigen Unterbrechungen aufweisen. Die vorgesehene Aufteilung der Versteifungsstruktur in die erfindungsgemäßen Versteifungsmodule stellt somit eine Abkehr vom bekannten Stand der Technik dar. Wie im Folgenden detaillierter erläutert, kann vorteilhaft hierdurch eine erhöhte Flexibilität hinsichtlich der Versteifung beliebig ausgestalteter Lastpfade, eine Vereinfachung der Fertigung sowie Einsparung von Material erreicht werden.

In Bezug auf das Verfügen der einzelnen Versteifungsmodule hat sich insbesondere das Laserstrahlschweißen als ein ausgezeichnetes Fügeverfahren zur Herstellung einer Verbindung der Gurte herausgestellt, wobei auch andere Verfahren zur Verbindung der Gurte bevorzugt sein können. Die Versteifungsstruktur erhält durch die Verbindungen einen durchlaufenden Gurt (auch im Folgenden als Gesamtgurt bezeichnet). Die formschlüssige, kraftschlüssige und/oder stoffschlüssige Verbindungen der jeweiligen Gurte der Module halten dabei hohen Belastungen stand, die beispielsweise in Unfallsituationen eines Fahrzeugs auftreten können, sodass an den Verbindungsstellen auch unter hohen Belastungen kein Bruch auftritt.

Im Gegensatz zu Versteifungsstrukturen des Standes der Technik können die Stege vorteilhaft so ausgestaltet sein, dass sie keine Verbindung der Versteifungsmodule zueinander darstellen. Dies führt dazu, dass die Stege der einzelnen Versteifungsmodule voneinander beabstandet werden können. Neben der vorteilhaften Ausgestaltung von nicht geradlinig verlaufenden Versteifungsstrukturen ermöglicht eine Beabstandung der jeweiligen Stege eine erhöhte Material- und eine damit einhergehende Gewichtsersparnis einer Versteifungsstruktur. Bekannte Versteifungsstrukturen aus dem Stand der Technik weisen demgegenüber sowohl einen durchgängigen Gurt und auch einen durchgängigen Steg auf.

Durch die Aneinanderreihung von Modulen wird eine Versteifungsstruktur erhalten mit einem Gesamtgurt und einem Gesamtsteg. Der Gesamtgurt ist dabei durch die einzelnen verbundenen Gurte der Verbindungsmodule durchgehend ausgestaltet, wohingegen der Gesamtsteg durch die Beabstandung der einzelnen Versteifungsmodule nicht durchgängig ausgestaltet ist und Freiflächen bzw. Aussparungen aufweist.

Vorteilhaft können für die Herstellung der einzelnen Versteifungsmodule konventionelle Herstellmethoden verwandt werden, wie diese beispielsweise auch für die Fertigung und Bearbeitung von Trägern bekannt sind. Im Sinne der Erfindung gehören zu den konventionellen Fertigungsverfahren bevorzugt Umformverfahren, Trennverfahren und/oder Fügeverfahren, welche durch ihre weite und schon Jahrzehnte lange Verbreitung eine sehr hohe Technologiereife aufweisen. Diesbezüglich sind diese Verfahren mit wenig Fehlern behaftet und besonders wirtschaftlich. Beispiele sind ausgesucht aus der Gruppe: Strangpressen, Biegen, Stanzbiegen, Kanten, Kleben, Verschrauben, Löten, diverse Schweißverfahren (MIG/MAG - Schweißen, E-Hand Schweißen ..), Walzen, Fräsen, Drehen, Schleifen, Bohren. Moderne additive Fertigungsverfahren (3D-Druck) gehören nicht zu den konventionellen Verfahren.

In einer bevorzugten Ausführungsform ist das Verfahren dadurch gekennzeichnet, dass die Stege der Versteifungsmodule mit dem Flächenelement Kontaktlinien bilden, wobei die Kontaktlinien der Stege entlang einer Versteifungsstruktur keine durchgängig ausgestaltete Linie darstellen. Eine derartige Ausgestaltung der Stege ermöglicht es im hohen Maße Material einzusparen. Es hat sich dabei gezeigt, dass es vorteilhaft nicht notwendig ist, eine Versteifungsstruktur zu generieren, welche einen durchgängigen Gesamtsteg aufweist. Sowohl Berechnungen der Statik, Simulationen als auch Realversuche an Prototypen haben gezeigt, dass die erfindungsgemäße Versteifungsstruktur mit beabstandeten Stegen eine hinreichende Versteifung ermöglichen, gleich einem durchgängigen Gesamtsteg der Versteifungsstruktur.

Im Sinne der Erfindung weisen die Stege bevorzugt eine Auflagefläche auf. Die Auflagefläche ist an einer von den Gurten abgewendeten Fläche der Stege ausgestaltet. Die Auflagefläche dient als Verbindungsfläche zwischen dem Flächenelement und der Versteifungsmodule. Mit anderen Worten sind die Versteifungsmodule über die jeweiligen Auflageflächen der Stege am Flächenelement angebracht. Die äußeren Konturen der Auflagefläche definieren somit die Kontaktlinien der Stege mit dem Flächenelement.

Weiterhin kann die Kontaktlinie bevorzugt auch als Längsachse und/oder Mittellinie der Auflagefläche definiert sein und im Wesentlichen parallel zum oder aufliegend auf dem Lastpfad liegen.

Begriffe wie im "Wesentlichen", "ungefähr", "etwa", "ca." etc. beschreiben bevorzugt einen Toleranzbereich von weniger als ± 40%, bevorzugt weniger als ± 20%, besonders bevorzugt weniger als ± 10 %, noch stärker bevorzugt weniger als ± 5% und insbesondere weniger als ± 1% und umfassen stets den exakten Wert. "Ähnlich" beschreibt bevorzugt Größen die "ungefähr gleich" sind. "Teilweise" beschreibt bevorzugt zu mindestens 5 %, besonders bevorzugt zu mindestens 10 %, und insbesondere zu mindestens 20 %, in einigen Fällen zu mindestens 40 %.

In einer weiteren bevorzugten Ausführungsform ist das Verfahren dadurch gekennzeichnet, dass die Kontaktlänge der Stege mit dem Flächenelement entlang eines Lastpfades kleiner ist als die Gesamtlänge der Versteifungsstruktur. Ebenso, wie schon in den vorhergehenden Absätzen beschrieben, generiert eine derartige Ausgestaltung die Beabstandung der Stege zweier benachbarter Versteifungsmodule innerhalb einer Versteifungsstruktur und/oder eines Versteifungssystems.

Bevorzugt ist die Kontaktlänge eines Steges diejenige Länge eines Versteifungsmoduls, welche entlang der Längsachse des Versteifungsmoduls in Kontakt mit dem Flächenelement steht. Dadurch, dass der Gurt der Versteifungsstruktur - durch die Verbindung der einzelnen Gurte der Versteifungsmodule - durchgängig ausgestaltet ist, wohingegen die Stege keine durchgängige Ausgestaltung aufweisen, ist die Kontaktlänge kleiner als die Gesamtlänge der Versteifungsstruktur. Es ist ebenfalls bevorzugt, dass die Kontaktlänge eines Steges eines Versteifungsmoduls kleiner ist als die Gesamtlänge des Versteifungsmoduls, wobei die Länge entlang der Längsachse des Moduls betrachtet wird.

Wie bereits obig erläutert, ist ein wesentliches Unterscheidungsmerkmal der Erfindung gegenüber dem Stand der Technik, dass die Versteifungsstruktur aufweisende Gesamtsteg (gebildet durch die einzelnen Stege der Versteifungsmodule) über seine gesamte Länge nicht durchgängig sein muss, sondern Materialaussparungen aufweisen kann. In seiner Gesamtheit wirkt die Versteifungsstruktur ähnlich einem bekannten Gitterträger bzw. Fachwerkträger oder Stabwerkträger. Die einzelnen Stege wirken dabei wie Stäbe, wobei ein Steg auch in der Art ausgestaltet sein kann, dass dieser durch bspw. Aussparungen oder Öffnungen wie eine Vielzahl von Stäben wirkt.

In einer bevorzugten Ausführungsform betrifft die Erfindung auch ein Verfahren für die Versteifung eines Flächenelementes umfassend:
- Bestimmung von topologieoptimierten Lastpfaden auf einem Flächenelement auf Basis von belastungsoptimierten Berechnungen und/oder Simulationen;
- Sequenzierung der Lastpfade in modulare Elemente;
- Konstruktion von Versteifungsmodulen anhand der erhalten Sequenzen;
- Fertigung von Versteifungsmodulen;
- aneinandergereihte Anbringung der Versteifungsmodule entlang der Lastpfade an dem Flächenelement, sodass die Versteifungsmodule eine gemeinsame Wirkung, nämlich die Versteifung und Verstärkung des Flächenelementes, entfalten.

In einem weiteren Aspekt betrifft die Erfindung ein Versteifungssystem umfassend eine Versteifungsstruktur und ein Flächenelement, wobei die Versteifungsstruktur mindestens zwei Versteifungsmodule umfasst, wobei die Versteifungsmodule aneinandergereiht einen Gurt und einen Steg umfassen und entlang eines topologieoptimierten Lastpfades wirkverbunden an dem Flächenelement angebracht vorliegen, wobei die Versteifungsmodule über Verbindungsmittel und/oder Fügeverfahren formschlüssig, kraftschlüssig und/oder stoffschlüssig an den jeweiligen Gurten miteinander verbunden vorliegen, sodass die Versteifungsmodule eine gemeinsame Wirkung, nämlich die Versteifung und Verstärkung des Flächenelementes, entfalten und wobei der Lastpfad für das Flächenelement topologieoptimiert anhand einer belastungsoptimierten Simulation und/oder Berechnungen erhalten wurde und nicht geradlinig ist.

Der Fachmann erkennt, dass bevorzugte Ausführungsformen und Vorteile, welche im Zusammenhang mit Verfahren zur Versteifung eines Flächenelementes offenbart werden, sich gleichermaßen auf das beanspruchte Versteifungssystem übertragen, und umgekehrt.

Die folgende Tabelle zeigt eine Übersicht, in welcher Verfahren aus dem Stand der Technik im Hinblick auf Gewichtsersparnis und Fertigungsdauer gegenübergestellt wurden.

| **Verfahren** | Herstellung Außenhaut + Einzelteile [min] | Nahtlänge gesamt [m] | Dauer Fügen/Generi eren [min] | **Gewichtsersparnis [%]** | **Fertigungsdauer insgesamt [min]** |
|---|---|---|---|---|---|
| **Stand der Technik** | 10 + 45 | 4 | 3 | **0** | **58** |
| **3D-Druck** | 10 + 0 | 240 | 444 | **20** | **454** |
| **Erfindung** | 10 + 40 | 4 | 40 | **20** | **90** |

Der Vergleich basiert auf einer 2m langen vertikalen Säule (als beispielhafte Versteifungsstruktur), die auf ein Blech (als Flächenelement) gefügt wird. Der "Stand der Technik" basiert auf der Verwendung konventioneller Fertigungsverfahren zur Fertigung einer durchgängigen Versteifungsstruktur. Für das erfindungsgemäße Verfahren wurden die beschriebene Sequenzierung in Versteifungsmodule vorgenommen und Fertigungsdaten für Laserschweißen und Laser-Pulver-Auftragsschweißen zu Grunde gelegt.

Die Erfindung erschließt dem Leichtbau breitere Anwendungsfelder und ermöglicht neuartige Produkte. Gegenüber dem Stand der Technik wird sich die ökologische Bilanz neuer, gewichtsoptimierter und ressourcenschonender Schiffe, Züge und Flugzeuge verbessern und nachhaltig helfen, über den gesamten Lebenszyklus CO2 Emissionen zu unterbinden. Durch die erzielbaren Kostenabsenkungen kann zudem eine hohe Marktdurchdringung erwartet werden, was sich wiederum als Multiplikator auf die erzielbaren CO2 Einsparungen auswirkt.

In einer bevorzugten Ausführungsform ist das Verfahren dadurch gekennzeichnet, dass die nachfolgenden Schritte umfasst sind:
- Bestimmung eines Lastpfades auf einem Flächenelement auf Basis von Berechnungen und/oder Simulationen
- Konstruktion eines Versteifungsmodells entlang des Lastpfades
- Sequenzierung des Versteifungsmodells entlang des Lastpfades in modulare Einheiten
- Konstruktion und Fertigung der Versteifungsmodule anhand durch die Sequenzierung erhaltenen modularen Einheiten.

Der beschriebenen Verfahrensschritte ermöglichen vorteilhaft die Herstellung einer besonders effizienten Versteifungsstruktur sowie Versteifungssystems, welche Versteifungsmodule umfassen. Es hat sich gezeigt, dass die Berechnungen und Simulationen zu idealen Lastpfaden auf einem Flächenelement führen, sodass entlang dieser idealen Lastpfade Versteifungsmodelle erstellt werden können.

Mittels (Computer-) Simulationen und Berechnungen kann das Verhalten von Bauteilen (Flächenelementen) und Baugruppen bestimmt werden. So kann im Vorfeld das physikalische Verhalten von Werkstoffen oder Bauteilen hinsichtlich Funktionalität, Stabilität oder Verformbarkeit getestet werden. Dies führt u.a. zu Einsparung von Kosten und Entwicklungszeit.

Die Berechnungen und/oder Simulationen von Lastpfaden auf einem Flächenelement erfolgt bevorzugt an einem Flächenelementmodell, wobei die einwirkenden Lasten vorgegeben werden. Bevorzugt werden Computerprogrammprodukte zur Strukturoptimierung, bspw. *Altair Obstruct*, für derartige Simulationen und Berechnungen verwendet.

Für die Bestimmung der Lastpfade kann beispielsweise ein Ereignis simuliert werden, bei dem ein Kastenwagen (FEM Modell) mit einer Geschwindigkeit von 60 Km/h auf einen Prellbock auffährt.

Die Lastpfade müssen jedoch auch nicht ausschließlich aus einer Crashsimulation hervorgehen. Stattdessen werden bevorzugt eine Vielzahl (beispielsweise mehr als 10) unterschiedliche reale Betriebsbelastungen überlagernd simuliert, um die Lastpfade zu erhalten.

Die Konstruktion eines Versteifungsmodells entlang der Lastpfade erfolgt bevorzugt anhand von CAD Programmprodukten. Beispiel für ein solches Computerprogrammprodukt ist Creo des Unternehmens *PTC Inc.* In einer bevorzugten Ausführungsform ist das Versteifungsmodell homogen ausgestaltet, sodass dieses zunächst bevorzugt keine Sequenzierung oder Strukturierungen im Sinne von Modulen aufweist.

In einer bevorzugten Ausführungsform ist das Versteifungsmodell bevorzugt ein Modell einer Versteifungsstruktur oder eines Versteifungsmoduls, wobei das Modell bevorzugt bereits (Modell)gurte und/oder (Modell)stege aufweist. In alternativen Ausführungsformen können die Modelle auch nur als Annäherungen bzw. Approximationen an die später anzufertigenden Versteifungsstruktur und/oder Versteifungsmodule ausgestaltet sein.

In einem weiteren bevorzugten Schritt wird die Konstruktion des Versteifungsmodells mittels Finite Elemente Methode überprüft. Hierfür kann beispielsweise das Computerprogrammprodukt *Altair Hypermesh* verwendet werden.

Die Sequenzierung des Versteifungsmodells entlang des Lastpfades in modulare Einheiten kann bevorzugt anhand unterschiedlicher Methoden erzeugt werden. Eine bevorzugte Variante ist die manuelle Erstellung der modularen Einheiten (Sequenzen) über ein CAD Programmprodukt, bspw. Creo der Firma *PTC Inc.* Darüber hinaus ist es bevorzugt die Sequenzierung automatisiert erfolgen zu lassen. Hierfür werden Algorithmen verwendet, die eine optimale Sequenzierung ermöglichen. Diese Algorithmen können unter anderem Algorithmen des maschinellen Lernens umfassen.

Es werden beispielweise nichtgeradlinig (kurvig) ausgestaltete ideale Versteifungsmodelle in lineare "Stücke" mathematisch angenähert, sodass lineare Bausegmente (Modelle) erhalten werden.

Nach der Sequenzierung des Versteifungsmodells können weitere simulierende und /oder berechnende Schritte umfasst sein, welche die die modularen Einheiten (Sequenzen) in Bezug auf Materialeinsparungen optimieren.

Nach der Sequenzierung des Versteifungsmodells werden bevorzugt Produktionsdaten zur Fertigung der einzelnen Versteifungsmodule erzeugt.

In einer weiteren bevorzugten Ausführungsform ist das Verfahren dadurch gekennzeichnet, dass der Lastpfad für das Flächenelement topologieoptimiert anhand einer belastungsoptimierten Simulation und/oder Berechnung erhalten wurde, wobei der Lastpfad bevorzugt nicht geradlinig ist. Die Bestimmung topologieoptimierter Lastpfade anhand von belastungsoptimierten Berechnungen erfolgt bevorzugt anhand oben genannter Schritte.

Es versteht sich, dass das Ziel der Topologieoptimierung vorzugsweise darin besteht, die Anforderungen an ein Bauteil (hier: bspw. das bevorzugte System, nämlich Flächenelement mit einer Versteifungsstruktur) mit möglichst geringem Materialeinsatz zu erfüllen. Bevorzugt wird dafür eine maximale Steifigkeit bzw. Verstärkung bei niedrigen Volumen angestrebt. Das bedeutet, dass die Versteifungsstruktur dem Flächenelement eine möglichst hohe Steifigkeit bzw. Versteifung verleihen soll, während die Versteifungsstruktur selbst und/oder das Flächenelement wenig Material benötigt und dementsprechend wenig Gewicht aufweist. Dies ermöglicht einen effizienteren Einsatz von Materialien und verbessert die Bewegungsdynamik durch eine geringere Masse.

Um eine optimale Versteifungsstruktur zu erhalten, sollte diese vorzugsweise entlang eines Lastpfades aufgebracht werden, der auf ein Flächenelement wirkt. Für eine optimale Lastenverteilung auf dem Flächenelement kann bevorzugt eine Berechnung der Lastpfade auf einem vordefinierten Flächenelement erfolgen. Idealerweise kann aufgrund der berechneten und/oder simulierten Lastpfade eine computerunterstützte Topologieoptimierung zum Einsatz kommen, wodurch bevorzugt eine optimale Formgebung für das Flächenelement, die Versteifungsstruktur und/oder dem System generiert wird. Davon ausgehend kann der Verlauf der Gurte und Stege der bevorzugten Versteifungsstruktur entsprechend der ermittelten optimalen Topologie und Lastpfade gestaltet werden.

Die Lastpfade können z. B. - wie weiter oben schon beschrieben - durch eine computergestützte Berechnung oder Simulation, insbesondere nach der Finite-Elemente-Methode, ermittelt werden. Sofern der Verlauf der Versteifungsstruktur bevorzugt an den Verlauf der ermittelten Lastpfade angepasst wird, kann eine erhöhte Steifigkeit des Flächenelements bei gleichzeitiger Gewichtsreduzierung erreicht werden.

Es versteht sich, dass bevorzugt eine topologieoptimierte Versteifungsstruktur erhalten wird, wenn diese auf einem Lastpfad ausgebildet ist, der auf einem topologieoptimierten bevorzugten System und/oder bevorzugten Flächenelement wirkt.

Vorzugsweise wird die Berechnung und/oder Simulation der Lastpfade in Abhängigkeit von einer vordefinierten Belastung bestimmt. Als vordefinierte Belastung ist zum Beispiel die Simulation und/oder Berechnung eines Aufpralls eines Kastenwagens auf einen Prellbock bei einer vorgegebenen Geschwindigkeit zu verstehen. Entsprechend der Belastung kann zum Beispiel ein Kastenwagen mit einer optimalen Topologie ermittelt werden, der ein besonders gutes Verhalten (in Bezug auf einen Schaden) bei der vorgegebenen Belastung aufweist, wobei ausgehend von der Topologieoptimierung bevorzugte Lastpfade generiert werden. Anschließend können entsprechend Versteifungsstrukturen und Flächenelemente erhalten werden.

Die vordefinierte Belastung ist bevorzugt optimal auf Anforderungen des zu versteifenden Flächenelementes ausgesucht. So unterliegt ein zu versteifendes Flächenelement in Zügen einer anderen Belastung als in Flugzeugen oder in einem Kastenwagen. Entsprechend werden im Sinne der Erfindung belastungsoptimierte Simulationen und/oder Berechnungen durchgeführt.

Der Begriff "nicht geradlinig" im vorliegenden Dokument ist bevorzugt synonym für "nichtlinear" oder auch "kurvig" zu verstehen. Eine nicht geradlinig verlaufende Versteifungsstruktur weist dabei innerhalb ihrer Gesamtlänge mindestens eine Richtungsänderung auf. Diese Richtungsänderung kann jede Raumachse umfassen.

Das vorgeschlagene durchdigitalisierte und automatisierte Verfahren (Fertigungskette) erlaubt vorteilhaft eine lokale Wertschöpfung, ohne auf global verteilte Liefernetzwerke angewiesen zu sein.

Durch die bevorzugte Sequenzierung topologieoptimierter Strukturen in (kleine) modulare Elemente besteht eine weitaus höhere Flexibilität gegenüber großen Einzelteilen. Module können schneller gefügt werden, als ein generatives Verfahren eine vergleichbare Struktur aufbauen kann. Im Gegensatz zu Ansätzen zur Umsetzung bionischer Strukturen aus dem Stand der Technik, ermöglicht die Erfindung daher die Realisierung größerer Bauteildimensionen, bei geringeren Fertigungszeiten und -kosten.

Die vorliegende Erfindung ermöglicht eine im Wesentlichen 20%ige Gewichtsersparnis bei erfindungsgemäßen Versteifungen gegenüber Konstruktionen aus dem Stand der Technik mit linear ausgestalteten Profilen.

Neben CO2-Einsparung durch den minimierten Energieverbrauch über den Lebenszyklus des Fahrzeugs ermöglicht die Erfindung CO2-Einsparung durch reduzierten Ressourcenbedarf für die Herstellung.

Das erfindungsgemäße Verfahren generiert bis zu ca. 80% Zeitersparnis gegenüber dem Aufbau mit 3D-Druck-Verfahren.

In einer bevorzugten Ausführungsform werden bekannte/konventionelle Fertigungsverfahren aus dem Stand der Technik zur Fertigung von Versteifungsmodulen verwendet und/oder miteinander kombiniert. Dies ist insbesondere dadurch möglich, weil die Versteifungsmodule keine geometrisch komplexen Strukturen aufweisen und auch bevorzugt mit einer kleinen geometrischen Ausgestaltung aufwarten.

Bevorzugt werden lastoptimierte bionische Strukturen aus industriell verfügbaren CAD-Systemen genutzt. Anstatt diese Strukturen mit dem herkömmlichen 3D-Druck identisch nachzubilden, werden sie auf Basis eines bevorzugten innovativen Konstruktionsprinzips mit sequenzierten Elementen modular aufgebaut. Durch eine digitale Datenbasis und Fertigungskette werden diese Elemente automatisiert positioniert und verzugsarm gefügt. Das bevorzugte Verfahren hat dadurch sehr viel höhere "Aufbauraten" als der 3D-Druck und ermöglicht die Integration bionischen Designs in die konventionelle Fertigung. Zusätzlich entfallen die dort bisher notwendigen zeitintensiven und komplexen Vorarbeitsschritte zur Einzelteilerzeugung sowie Projektvorlaufzeiten und kostenintensiven Vorrichtungen.

Die Erfindung setzt bevorzugt auf digitalisierte und automatisierte Prozessketten.

Insbesondere hat sich für die Erfinder gezeigt, dass die Erfindung eine breite industrielle Anwendung und branchenübergreifende Verwendung des Konstruktionsprinzips aufweist. Zudem ermöglicht die Erfindung die Erschließung eines höheren Digitalisierungslevels in der Fahrzeug-Rohbaufertigung (Flugzeug-, Schiff- und Schienenfahrzeugbau, etc.) für gängige metallische Werkstoffe (Fe, AI, Ti, Mg).

Weitere Vorteile umfassen:
- digitalisierte u. automatisierte Prozessketten
- Modellierung aller Prozess-Schritte
- Simulation der Fertigungskette
- Prozessablauf von der Platine bis zum Endprodukt digital abgebildet
- Bauteiloptimierung, Serientauglichkeit, Optimierung Fertigungsaufwand
- Neues Konstruktionsprinzip ermöglicht bis zu 20% Gewichtsersparnis durch bionisch optimierte Strukturen
- Reduktion manueller Arbeitsschritte
- Modularisierte Einheiten werden automatisiert zu konventionell nicht erzeugbaren Strukturen gefügt

Durch die Fokussierung auf den Metall-Leichtbau profitieren auch Nachhaltigkeit und Recyclingsfähigkeit der Industrien im Vergleich zum kunststoffbasierten Faserverbund-Leichtbau. Durch Instandsetzung mittels weit verbreiteter Reparaturtechnologien (u.a. Schweißen) erreichen z.B. Schienenfahrzeuge Einsatzzeiten von über 30 Jahren. Des Weiteren lassen sich metallische Werkstoffe zu 100% als Sekundärrohstoff wiederverwenden.

Bevorzugt basiert das Verfahren auf den bionischen Prinzipien, nach denen organische Strukturen in der Natur gemessen an ihrem Eigengewicht sehr große Lasten tragen und Kräfte aufnehmen können. Der bionische Ansatz bietet eine Querschnittsfunktion in alle Branchen, insbesondere im Sektor Mobilität. Eine branchenübergreifende Systemlösung wird angestrebt.

Das erreichbare Einsparpotential des beschriebenen Verfahrens in Bezug auf Material, Gewicht und CO2-Emission soll im Folgenden beispielhaft für den Schienenfahrzeugbau und die Luftfahrt illustriert werden.

### Beispiel Schienenfahrzeugbau

Die mögliche Gewichtsersparnis in der Versteifungsstruktur eines Stahlleichtbau-Schienenfahrzeugs (ICE4) durch bionische Optimierung ist ca. 200kg pro Wagenkasten (ca. 20% bezogen auf die Versteifungsstruktur in den Seitenwänden). Daraus ergeben sich bei einem Zug mit 13 Wagen eine Gewichtsreduktion von ca. 2,73t.
- Primäreinsparung: Durch den verringerten Materialeinsatz ergibt sich eine CO2 Einsparung von ca. 3,98t CO2 pro Zug. Berechnungsmethode: 2,73t Gewichtseinsparung x 1,46CO2/t CO2 Ausstoß pro Tonne Stahlfertigerzeugnis [2]
- Einsparung über die Lebensdauer: Es ergibt sich ein Einsparpotential von 176,68t CO2 für einen Zug mit bionisch optimierten Verstärkungsstrukturen in den Seitenwänden über die Lebensdauer. Berechnungsmethode: Verhältnisrechnung auf Basis von Referenzdaten [3], [4].
- Die CO2 Einsparung über die Lebensdauer durch 416kg Gewichtsreduzierung pro Wagenkasten durch CFK Nutzung beträgt 350t. Aus 200kg Gewichtsreduzierung pro Wagenkasten ergibt sich für die Projektidee eine Einsparung von 176,68t CO2

### Beispiel Luftfahrt

Die mögliche Gewichtsersparnis durch Verwendung einer bionisch optimierten Versteifungsstruktur (Stringer) in Aluminiumbauweise ist ca. 20% [5].

Beispielrechnung mit einer Gewichtsersparnis von 5,33t pro Flugzeug (Typ A320) [6]:
- Primäreinsparung: Durch den verringerten Materialeinsatz ergibt sich eine CO2 Einsparung von 49,79t CO2 pro Flugzeug (Typ A320). Berechnungsmethode: 5,33t Gewichtseinsparung x 9,34t CO2 Ausstoß pro Tonne Primäraluminiumerzeugung [7].
- Einsparung über die Lebensdauer: Es ergibt sich ein Einsparpotential von 33.597t CO2 für ein Flugzeug (Typ A320) mit bionisch optimierten Verstärkungsstrukturen im Rumpf (5,33t Gewichtseinsparung) über eine angenommene Nutzungsdauer von 25 Jahren. Berechnungsmethode: 10.000 Liter Kerosineinsparung pro 100kg Gewichtsersparnis pro Flugzeug (Typ A320) pro Jahr [8]. 1 Liter Kerosin wiegt ca. 0,8kg. Gemäß CO2 Emissionsfaktor ergeben sich 3,15kg emittiertes CO2 pro kg Kerosin [9].

Die erfindungsgemäße automatisierte und digitalisierte Prozesskette ist bevorzugt als genereller technologischer Ansatz zu verstehen. Aufgrund der gegebenen bionischen Gestaltungsfreiheit ist das Konstruktionsprinzip vorteilhaft universell anpass- und anwendbar. Das Leichtbaupotential der Erfindung ist für alle Branchen verfügbar, insbesondere im Mobilitätssektor ergibt sich über den Lebenszyklus der Produkte eine maximale CO2 Einsparung. Für die einzelnen Prozessschritte gibt es anfängliche technische Insellösungen, die die Erfindung in einer überzeugenden Weise miteinander kombiniert werden sollen.

Darüber hinaus ist das Verfahren durch die Fertigungsmöglichkeiten der Versteifungsmodule mittels konventioneller Methoden überaus wirtschaftlich durchführbar.

In einer bevorzugten Ausführungsform ist das Verfahren dadurch gekennzeichnet, dass ein Versteifungsmodul einen Gurt, einen Steg und eine Auflagefläche aufweist, wobei an einer ersten Stirnseite des Steges ein Gurt ausgestaltet ist und die zweite Stirnseite als Auflagefläche dient.

In einer bevorzugten Variante der Erfindung sind ein Steg sowie ein Gurt eines Moduls keine einzelnen Bauteile, sondern dienen nur als Bezeichnung verschiedener Bauteilelemente des Versteifungsmoduls. Alternativ können der Steg und der Gurt einer Versteifungsmoduls jedoch auch aus verschiedenen Bauteilen bestehen, sodass diese miteinander über Verbindungsmittel und/oder Fügeverfahren miteinander verbunden werden, so dass sie gemeinsam ein Versteifungsmodul bilden.

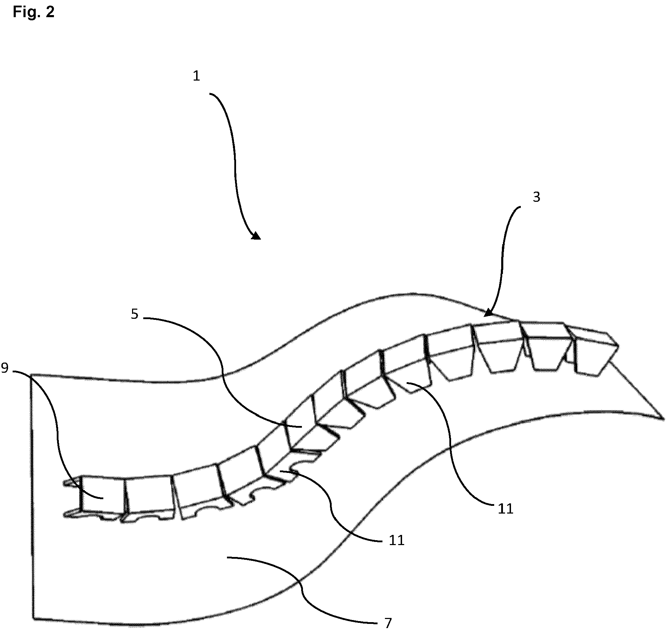

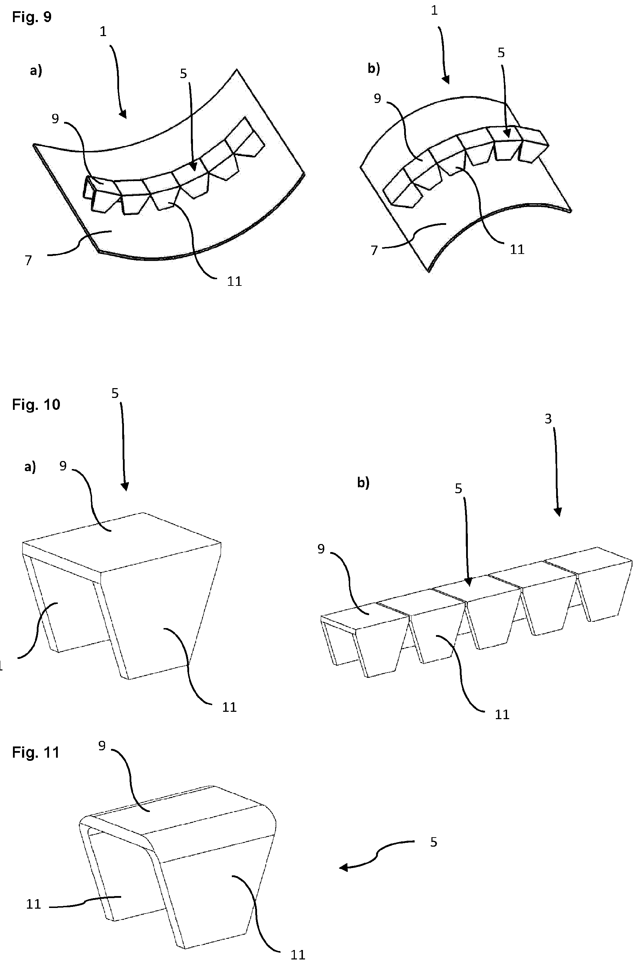

Ein Flächenelement ist bevorzugt ein dreidimensionaler Gegenstand, welcher in seiner Breite und/oder Länge sehr viel größer ist als seine Dicke. Flächenelemente können zum Beispiel auch Wände, Wandelemente, Bleche, Platten sein. Dabei können die Flächenelemente planar oder aber auch Unebenheiten wie Wölbungen (zum Beispiel: konvex oder konkav, Fig. 2 oder Fig. 9), Furchen, Sicken und/oder Erhebungen aufweisen. Die Flächenelemente sind bevorzugt eingesetzt in Fahrzeugen (auch Wasserfahrzeuge) und/oder Flugzeugen. Besonders bevorzugt werden die Flächenelemente in den Fahrzeugen zur Konstruktion der tragenden Hülle verwandt (u.a. Seitenwände, Rumpf, insbesondere Flugzeugrumpf oder Schiffsrumpf).

Unter dem Begriff Sequenzierung ist bevorzugt auch eine Diskretisierung zu verstehen.

In einer weiteren bevorzugten Ausführungsform ist das Verfahren dadurch gekennzeichnet, dass die Stege der Versteifungsmodule Auflageflächen aufweisen und die Versteifungsmodule an den Auflageflächen am Flächenelement angebracht werden. Die Auflageflächen sind dabei bevorzugt an den Stirnseiten der Stege ausgestaltet. Sie sind dabei ausreichend groß, um eine einfache und stabile Verbindung zwischen Flächenelement und Versteifungsmodul zu gewährleisten.

In einer weiteren bevorzugten Ausführungsform ist das Verfahren dadurch gekennzeichnet, dass die Fertigung der Versteifungsmodule durch Trennverfahren, bevorzugt Laserschneiden, Stanzen und/oder Umformverfahren, bevorzugt Kanten, Pressen und/oder Biegen erfolgt, wobei der Steg und der Gurt eines Versteifungsmoduls
(i) aus jeweils separaten Halbzeugen gefertigt werden, sodass der Steg und der Gurt miteinander verbunden werden oder;
(ii) aus einem identischen Halbzeug mittels Umformverfahren gefertigt werden.

Die Verwendung konventioneller Fertigungsmethoden ermöglicht es das bevorzugte Verfahren vorteilhaft wirtschaftlich zu gestalten. Darüber hinaus sind die konventionellen Methoden aufgrund ihrer technologischen Reife wenig fehleranfällig.

Bevorzugte Trennverfahren sind ausgesucht aus der Gruppe umfassend: Laserschneiden, Stanzen, Fräsen, Schleifen, Bohren, Sägen, Senkerodieren, Drahterodieren. Bevorzugte Umformverfahren sind ausgesucht aus der Gruppe: Kanten, Pressen, Biegen, Tiefziehen, Walzen

Das Herstellen der Versteifungsmodule kann bevorzugt in zwei Varianten erfolgen. So werden zunächst aus weiter oben beschriebenen Berechnungs- und Simulationsschritten Produktionsdaten der Einzelteile (Versteifungsmodule) erzeugt. Anschließend können sie bevorzugt über
a) Laserschneiden und Kanten oder;
b) Stanzbiegen
gefertigt werden.

In einer weiteren bevorzugten Ausführungsform werden die Versteifungsmodule "Just in Time" gefertigt, sodass die Module in der Fertigungsanlage bereitgestellt werden, ohne zwischengelagert zu werden. Die Vorteile einer "Just in Time" Produktion sind dem Fachmann hinlänglich bekannt und müssen im vorliegenden Dokument nicht im Weiteren erläutert werden.

In einer weiteren bevorzugten Ausführungsform werden die Versteifungsmodule gelagert, wobei vorzugsweise ein hoher Automatisierungsgrad bei der Lagerung erreicht wird. Durch eine hohe Automatisierung können weiterhin die Kosten für die Lagerung gesenkt werden und demnach auch die Wirtschaftlichkeit der Versteifungsstruktur in ihrer Gesamtheit verbessert werden.

Nachdem die einzelnen Versteifungsmodule gefertigt wurden, werden sie zu einer Versteifungsstruktur bzw. einem Versteifungssystem weiterverarbeitet. Dies erfolgt bevorzugt anhand des manuellen Einsetzens einzelner Versteifungsmodule in ein zu versteifendes Flächenelement, bevorzugt ein Blech. In einer alternativen Ausführungsform erfolgt der Prozess automatisiert, bspw. über ein Greifrobotersystem. So werden einzelne Versteifungsmodule aus einer Vielzahl von bereitgestellten Modulen zunächst automatisiert erkannt, anschließend gegriffen und anschließend in ein Flächenelement, bevorzugt Blech, positioniert. Jedes einzelne Versteifungsmodul wird dann bevorzugt gefügt (Verbindung mit dem Blech) bevor das nächste eingesetzt wird.

Nachdem die Versteifungsmodule positioniert sind, bevorzugt aneinandergereiht entlang eines Lastpfades, werden die Versteifungsmodule durch Fügeverfahren miteinander verbunden, wobei besonders bevorzugt nur die Gurte der jeweiligen Module miteinander verbunden werden.

In einer weiteren bevorzugten Ausführungsform ist das Verfahren dadurch gekennzeichnet, dass das Flächenelement ein zu versteifendes Bauteil, bevorzugt ein Rohbauteileines Fahrzeuges, bevorzugt ausgewählt aus einer Gruppe umfassend Schienenfahrzeug, Flugzeug oder Schiff.

In einer weiteren bevorzugten Ausführungsform ist das Verfahren dadurch gekennzeichnet, dass das Flächenelement ein zu versteifendes Bauteil ist, welches Abmaße von mehr als einem Meter aufweist. Ein derartiges Bauteil kann auch als Großbauteil bezeichnet werden. Vorteilhaft erlaubt die Erfindung eine Versteifung auch großflächiger Flächenelemente und zeichnet sich somit insbesondere für die Versteifungs von Großbauteilen für den Fahrzeugrohbau aus.

In einer weiteren bevorzugten Ausführungsform findet das Verfahren Anwendung in der Rohbaufertigung von Fahrzeugen, insbesondere zur Versteifung tragender Rohbauteile.

Im Sinne der Erfindung weist das Flächenelement bevorzugt Abmaße von mehr als einem Meter, stärker bevorzugt mehr als 1,5 Meter und insbesondere mehr als 2 Meter auf. Gerade bionische nichtlineare Versteifungsstrukturen für die benannten Maße sind im Stand der Technik nicht bekannt.

In einer weiteren bevorzugten Ausführungsform ist das Verfahren dadurch gekennzeichnet, dass die Versteifungsmodule an den Auflageflächen an ein Flächenelement angebracht werden.

In einer weiteren bevorzugten Ausführungsform ist das Verfahren dadurch gekennzeichnet, dass die Versteifungsmodule über Verbindungsmittel und/oder Fügeverfahren formschlüssig, kraftschlüssig und/oder stoffschlüssig miteinander verbunden werden.

In einer weiteren bevorzugten Ausführungsform ist das Verfahren dadurch gekennzeichnet, dass die Versteifungsmodule durch Fügeverfahren miteinander verbunden werden ausgesucht aus der Gruppe umfassend: Schweißen, bevozugt Laserstrahlweißen, Lichtbogenschweißen, Elektronenstrahlschweißen und/oder Widerstandspunktschweißen sowie Löten, Schrauben, Nieten, Kleben.

Die Verbindung einzelner Module anhand von nachträglich verwendeter Fügeverfahren für einen Erhalt einer gemeinsamen Versteifungstruktur, gilt als Abkehr zum Stand der Technik. Wie eingangs beschrieben, werden für die Versteifung von Flächenelementen üblicherweise lineare Profilträger verwendet, welche bevorzugt anhand eines Strangpressverfahrens als ein durchgängiges Bauteil (bevorzugt als ein Strang) gefertigt werden. Weiterhin bevorzugt können lineare Profilträger üblicherweise auch über ein 2D-Laseschneiden und einem abschließenden Abkanten hergestellt werden. Ein weiteres Herstellverfahren ist das 2D Laserschneiden gefolgt von 2D Laserschweißen (Tailored Blank Herstellung) gefolgt von Tiefziehen gefolgt von 3D Laserbeschnitt. Unterbrochene Träger werden dabei bisher für eine Versteifung als nicht geeignet erachtet. Die erfindungsgemäße Versteifungsstruktur bzw. das erfindungsgemäße Vertseifungssystem ist hingegen aus vielen einzelnen Versteifungsmodulen hergestellt. Es war überraschend, dass ein nachträgliches Fügen, insbesondere anhand eines Laserstrahlschweißens, der einzelnen Versteifungsmodule zu einer besonders stabilen und steifen Versteifungsstruktur führt, sodass selbst bei hohen Belastungen die Verbindungen nicht nachgeben.

Die Nutzung des Laserstrahlschweißens ist darüber hinaus auch mit weiteren Vorteilen versehen. So kann anhand des Laserstrahlschweißens durch einen punktgenauen und präzisem Energieeintrag besonders detailiert und exakt eine Verbindung der Gurte benachbarter Versteifungsmodule hergestellt werden. Darüber hinaus ist die Einwirkung auf das Gefüge als sehr gering anzusehen, wordurch die zu verbindenen Versteifungsmodule nur einen geringen thermischen Verzug aufweisen.

Auch kraftschlüssige Fügeverfahren, wie das Schrauben oder Nieten können - abhängig vom Material - bevorzugt sein. Derartige Verbindungen sind besonders kostengünstig. Dadurch, dass die Stege nebeneinander gereihter Versteifungsmodule voneinander beabstandet sind - und dadurch Freiflächen zwischen den Modulen entstehen - , ist eine gute zugänglichkeit der Schraub und Nietverbindungen gewährleistet.

In einer bevorzugten Ausführungsform ist das Fügeverfahren automatisiert und durch die nachfolgenden Schritte definiert:
- sensorgeführtes Fügen (bevorzugt Laserstrahlschweißen) programmierter Bahnen bei Kehlnähten (Steg-Flächenelement)
- sensorbasierte (Bildverarbeitung) Anpassung programmierter Bahnen (Gurt-Gurt Verbindung)

Insbesondere die Gurt-Gurt Verbindungen zweier Versteifungsmodule, lässt sich gut über ein kamerabasiertes System überprüfen, sodass die Schweißnähte anhand der Bilderkennungsalgorithmen angepasst werden kann,

In einer bevorzugten alternativen Ausführungsform ist das Fügerverfahren automatisiert und durch die nachfolgenden Schritte definiert:
- Erkennung der Positionen der Versteifungsmodule
- Berechnung der benötigten Verbindungsnähte
- Anspassung vorhandener Standard-Nähte
- Sensorgeführtes Fügen der erzeugten Bahnen (Steg-Flächenelement)
- Fügen von Nahtstellen (Gurt-Gurt) mittels vorher angepasster Bahnen

In einer bevorzugten alternativen Ausführungsform ist das Fügerverfahren (teil-) automatisiert, z.B. anhand programmierter Bahnen (Steg-Flächenelement-Verbindung und Gurt-Gurt Verbindung)

In einer weiteren bevorzugten Ausführungsform ist das Fügeverfahren als ein manuelles Verfahren definiert. So können Steg-Flächenelement-Verbindungen über beispielsweise über ein Handschweißverfahren, gefügt werden. Selbiges könnte auch für die Gurt-Gurt Verbindungen gelten.

In einer weiteren bevorzugten Ausführungsform ist das Fügeverfahren aus eine kombination der vorher genannten Verfahren definiert.

Die Erfindung betrifft ein Versteifungssystem umfassend eine Versteifungsstruktur und ein Flächenelement, wobei die Versteifungsstruktur mindestens zwei Versteifungsmodule der eingangs genannten Art umfasst, wobei
die Versteifungsmodule einen Gurt und einen Steg umfassen und
die Versteifungsmodule aneinandergereiht entlang eines Lastpfades wirkverbunden an dem Flächenelement angebracht vorliegen, wobei die Versteifungsmodule über Verbindungsmittel und/oder Fügeverfahren formschlüssig, kraftschlüssig und/oder stoffschlüssig an den jeweiligen Gurten miteinander verbunden vorliegen, sodass die Versteifungsmodule eine gemeinsame Wirkung entfalten, wobei der Lastpfad für das Flächenelement topologieoptimiert anhand einer belastungsoptimierten Simulation und/oder Berechnungen erhalten wurde und nicht geradlinig ist.

Die Vorteile und bevorzugten Ausführungsformen des erfindungsmäßen Verfahrens sind analog auf das erfindungsgemäße Versteifungssystem zu übertragen, und umgekehrt.

In einer bevorzugten Ausführungsform ist die Versteifungsstruktur dadurch gekennzeichnet, dass ein Versteifungsmodul einen Gurt, einen Steg und eine Auflagefläche aufweist, wobei an einer ersten Stirnseite des Steges ein Gurt ausgestaltet ist und die zweite Stirnseite als Auflagefläche dient.

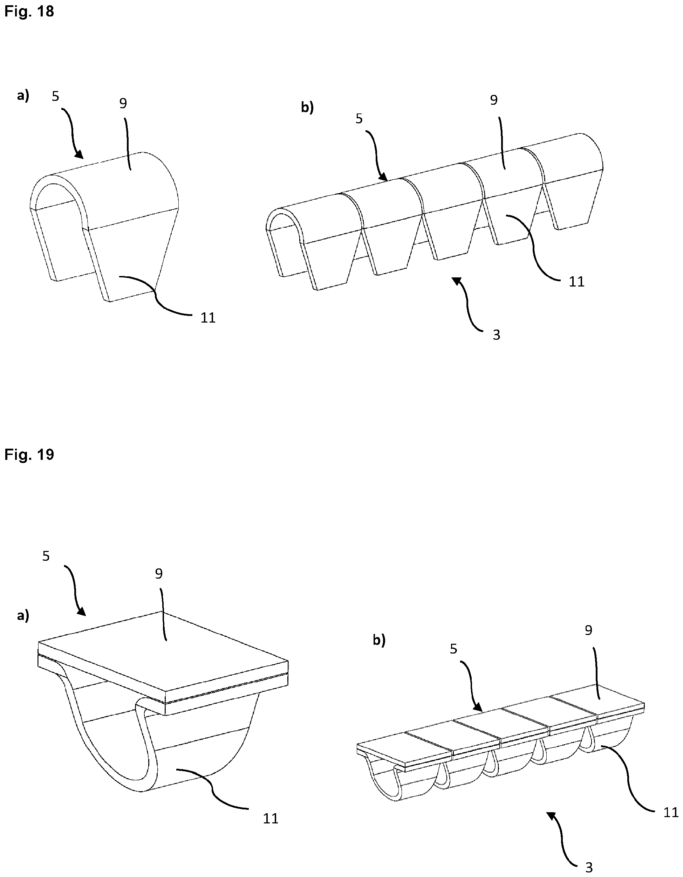

In einer bevorzugten Ausführungsform weisen die Versteifungsmodule jeweils einen planar ausgestalteten Gurt auf. Ein solcher Gurt erlaubt einen guten Kraftfluss in der Ebene und eine platzsparende Integration (vgl. Fig. 9-12). Es kann aber ebenso bevorzugt sein einen bogenförmigen Gurt zu verwenden, welcher sich durch eine besonders hohe Stabilität in entlang der Wölbung auszeichnet (vgl. u.a. Fig. 18).

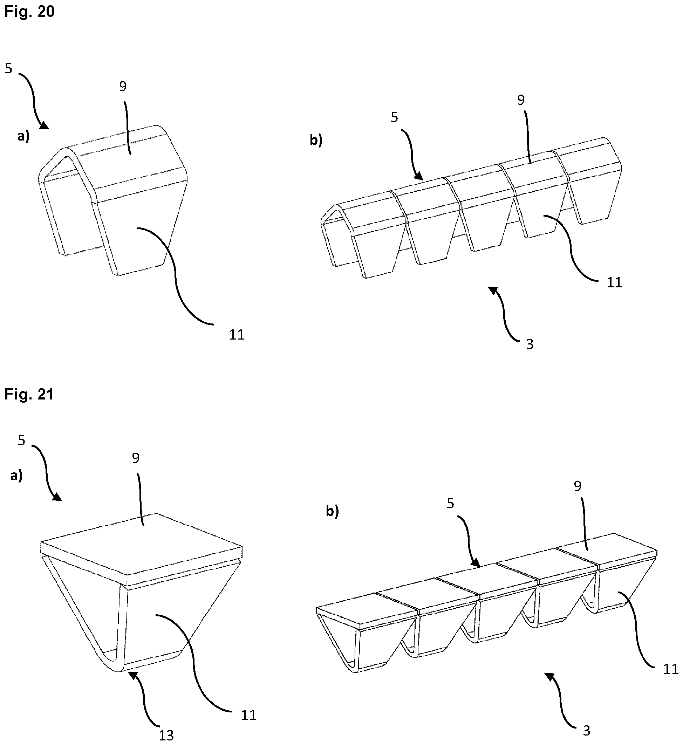

In einer weiteren bevorzugten Ausführungsform sind die Gurte der Versteifungsmodule durch zwei aufeinander zulaufende Flächen definiert. Diese Flächen stehen bevorzugt in einem spitzen Winkel zueinander (vgl. u. a. Fig. 20). Derartige Ausgestaltungen der Gurte ermöglichen vorteilhaft ein erhöhtes Platzaufkommen unterhalb der Gurte, sodass weitere Bauelement eingebracht vorliegen können.

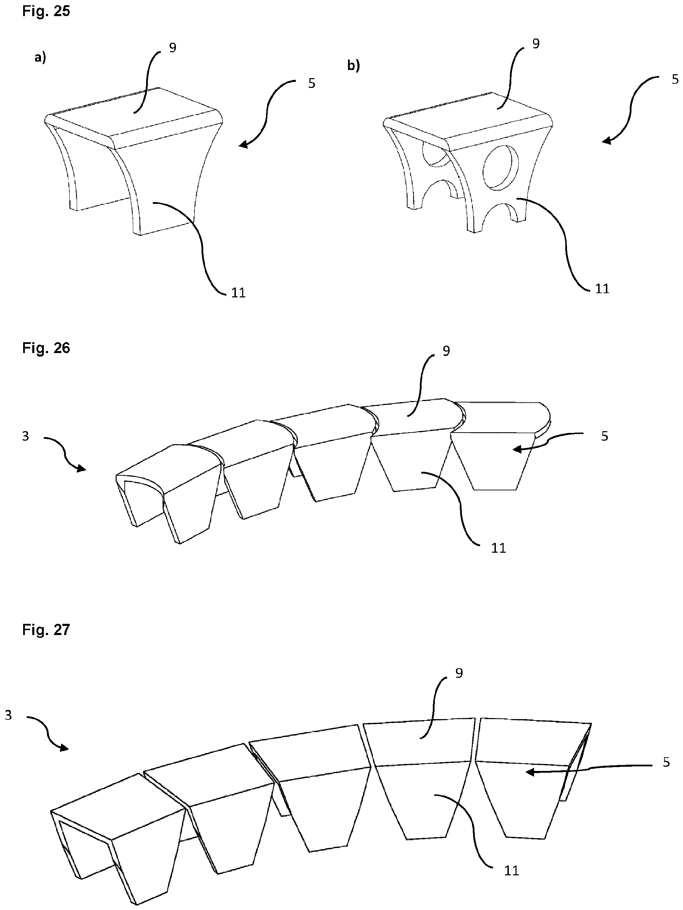

Darüber hinaus können in weiteren bevorzugten alternativen Ausführungsformen die Gurte auch in der Art ausgestaltet sein, dass die Gurte jeweils eine konvexe sowie konkave Stirnseite aufweisen. Neben einer stoffschlüssigen Verbindung kann die konvexe Stirnseite eines Gurtes eines Versteifungsmoduls in die konkave Stirnseite eines benachbarten Versteifungsmoduls aufgenommen werden, sodass eine diese ebenfalls formschlüssig verbunden sind (vgl. Fig. 26 und Fig. 27). In bevorzugten weiteren Ausgestaltungen weisen die Gurte geradlinig ausgestaltete Gurtstirnseiten auf, über welche die Versteifungsmodule miteinander aneinandergereiht verbunden sind.

In einer bevorzugten Ausführungsform weisen die Versteifungsmodule ein, zwei oder mehr Auflagefläche auf. Bevorzugt werden die Auflageflächen durch die Stege gebildet. Im Falle eines Steges pro Versteifungsmodul kann es bevorzugt sein, genau eine Auflagefläche auszubilden. Im Falle zweier oder mehr Stege können auch mehrere Auflageflächen gebildet werden. In bevorzugten Ausführungsformen weisen die Stege zu diesem Zweck einen flache Stegabsatz auf, welcher planar auf dem Flächenelement aufgebracht werden kann (vgl. u.a. Fig. 9-12). Es kann aber ebenso bevorzugt sein den Steg als offenen Ring mit einem Querschnitt in C-Form auszugestalten (vgl. Fig. 19). Die Auflagefläche des im Querschnitt als C ausgestalteten Stegs ist bevorzugt auf der nach außen gerichteten Fläche, welche gegenüberliegend der Freifläche des C's positioniert ist. Der im Querschnitt als C ausgestalteter Steg ist demnach liegend ausgeführt, sodass auf dem Spalt des C's bevorzugt ein Gurt angebracht werden kann. Mit einem Steg in Form dieser Ausgestaltung kann die Auflagefläche minimiert werden, wobei trotzdem die nötige Versteifung erreicht werden kann. Bevorzugt kann die Auflagefläche zu einer Auflagelinie, je nach Radius des C's, ausgestaltet sein.

In einer weiteren bevorzugten Ausführungsform ist die Versteifungsstruktur dadurch gekennzeichnet, dass die Versteifungsmodule jeweils zwei oder mehr Stege aufweisen. Die Stege können beispielsweise parallel zu einander ausgerichtet sein und senkrecht zum Gurt angeordnet sein (vgl. u.a. Fig. 9 oder 10). Bevorzugt können die Stege eine Verjüngung ausgehend vom Gurt zur Auflagefläche aufweisen, sodass zwischen den Stegen ein Spalt bzw. eine Öffnung entsteht. Die Verjüngung des Steges kann bevorzugt linear erfolgen oder aber auch nicht-linear, beispielsweise exponentiell. Darüber hinaus kann sich der Steg ausgehend vom Gurt hin in Richtung zur Auflagefläche bevorzugt verjüngen, anschließend wieder verbreitern und dann wieder verjüngen, sodass der Steg von einer Seitenansicht eine konvexe Form annimmt.

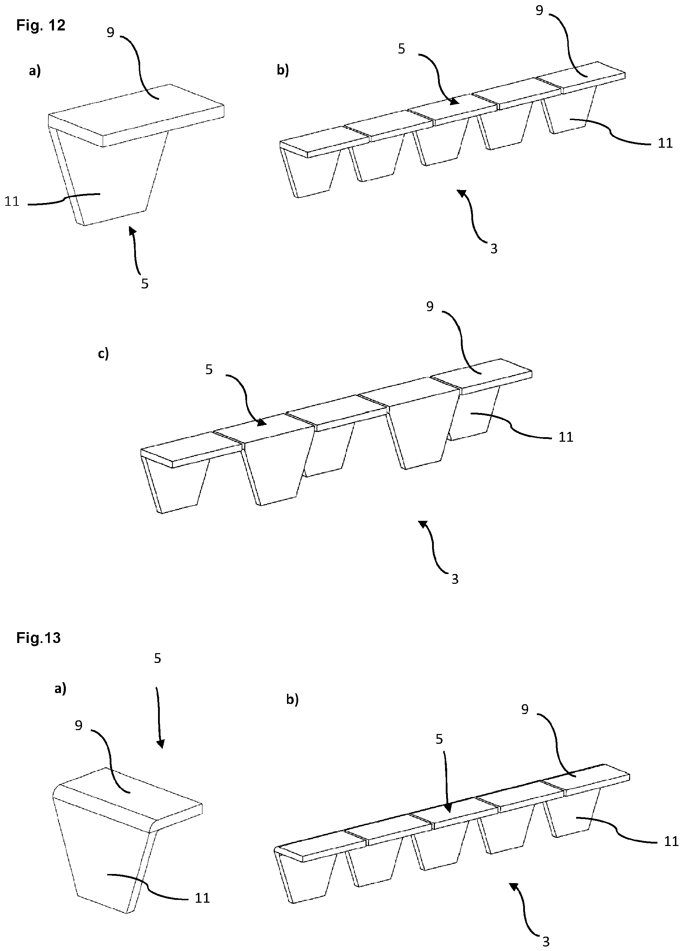

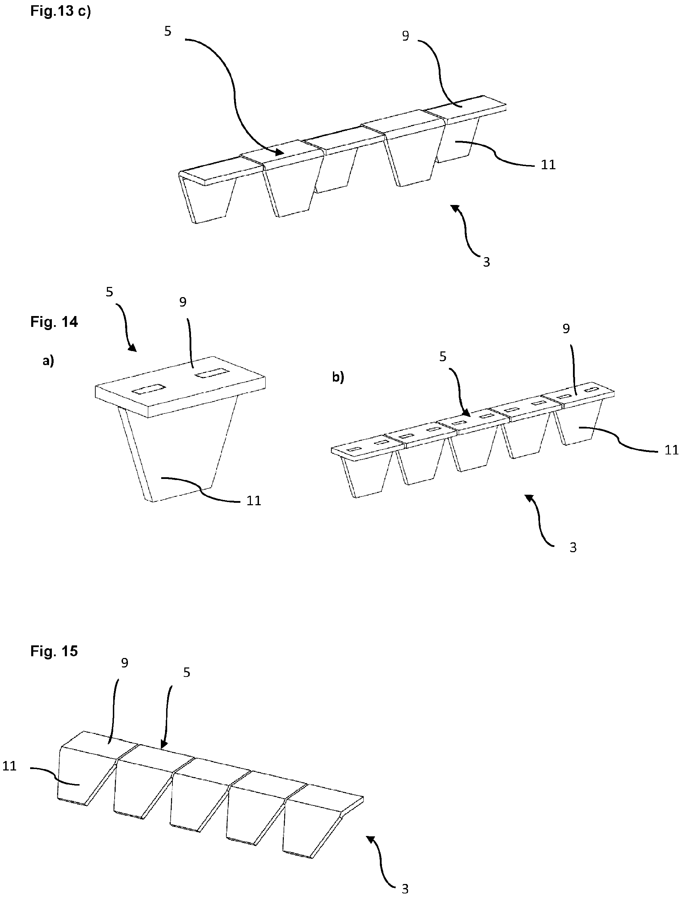

In einer bevorzugten Ausführungsform ist die Versteifungsstruktur dadurch gekennzeichnet, dass die Versteifungsmodule jeweils einen Steg aufweisen. Beispielsweise kann es bevorzugt sein den einen Steg im Wesentlichen mittig in Bezug auf den Gurt zu positionieren (vgl. u.a. Fig. 14). Es kann aber ebenso bevorzugt sein, den einen Steg an einer Seite der jeweiligen Gurte zu positionieren (vgl. Fig. 13b) oder aber alternierend an gegenüber liegenden Seiten der jeweiligen Gurte (vgl. Fig. 13c). Gerade im Hinblick auf eine topologieoptimierte Versteifungsstruktur können bevorzugt bereichsweise Stege nur einseitig an Gurten befestigt sein, um einen definierten Lastpfad nachzuempfinden. Sehr stark bevorzugt weisen Versteifungsstrukturen, welche bereichsweise (1.Bereich) einseitig ausgestaltete Stege aufweisen an weiteren Bereichen (2. Bereich) ebenfalls einseitig ausgestaltetet Stege auf. Die Stege im zweiten Bereich weisen dabei im Vergleich zum ersten Bereich die Stege auf der gegenüberliegenden Seite auf. Ein Bereich ist durch mindestens zwei hintereinander angeordnete Versteifungsmodule definiert. Bevorzugt kann ein Bereich auch 3 oder 5 Module umfassen (vgl. Fig 12b und Fig. 13b),

In einer weiteren bevorzugten Ausführungsform ist die Versteifungsstruktur dadurch gekennzeichnet, dass die Versteifungsmodule über Verbindungsmittel und/oder Fügeverfahren formschlüssig, kraftschlüssig und/oder stoffschlüssig miteinander verbunden sind. Die im Zusammenhang mit den Verfahren offenbarten Vorteile gelten analog, wobei ein Fachmann anhand der fertigen Versteifungsstruktur feststellen kann, welches Verbindungs- oder Fügeverfahren verwendet wurden.

In einer weiteren bevorzugten Ausführungsform ist die Versteifungsstruktur dadurch gekennzeichnet, dass der Lastpfad für das Flächenelement topologieoptimiert anhand einer belastungsoptimierten Simulation erhalten wurde, wobei der Lastpfad bevorzugt nicht-linear ist.

Die Ausgestaltung der Versteifungsmodule kann demnach bevorzugt je nach Flächenelement topologieoptimiert sein, wobei auch innerhalb einer Versteifungsstruktur unterschiedliche Versteifungsmodule eingesetzt werden können.

In einer weiteren bevorzugten Ausführungsform ist die Versteifungsstruktur dadurch gekennzeichnet, dass der Gurt oder Steg des Versteifungsmoduls aus einem Material ausgestaltet ist ausgewählt aus der Gruppe umfassend Verbundstoff, Stahl, Titan, Nichteisenmetall (bevorzugt Aluminium, Kupfer, Nickel, Blei oder Magnesium) und Kunststoff. Ein Verbundstoff kann bspw. die Kombination aller benannten Materialien umfassen.

Das Material der Versteifungsmodule kann bevorzugt auch kombiniert werden. Besonders bevorzugt werden Versteifungsmodule aus Aluminium und/oder Stahl ausgearbeitet.

In einer weitere bevorzugten Ausführungsform weist die Versteifungsstruktur walzbare Werkstoffe/Halbzeuge oder Werkstoffe/Halbzeuge hergestellt aus einer Extrusionspresse auf. Hierzu gehören beispielsweise Aluminium, Stahl oder auch Kunststoff. Holz hingegen ist kein walzbarer Werkstoff im Sinne der Erfindung.

In einer weiteren bevorzugten Ausführungsform betrifft die Erfindung ein Versteifungssystem umfassend eine Versteifungsstruktur der oben beschriebenen Art und ein Flächenelement dadurch gekennzeichnet, dass
- die Versteifungsstruktur entlang eines Lastpfades an dem Flächenelement angebracht vorliegt
- die Versteifungsmodule der Versteifungsstruktur Auflageflächen aufweisen und über die Auflagenflächen am Flächenelement angebracht sind.

Die Vorteile und bevorzugten Ausführungsformen der beschriebenen Versteifungsstruktur sowie des beschriebenen Verfahrens übertragen sich analog auf das Versteifungssystem, und umgekehrt. So wird der Lastpfad für das Flächenelement erfindungsgemäß topologieoptimiert anhand einer belastungsoptimierten Simulation und/oder Berechnungen erhalten, wobei der Lastpfad nicht geradlinig ist.

In einer weiteren bevorzugten Ausführungsform ist das Versteifungssystem dadurch gekennzeichnet, dass die geometrische Ausgestaltung der Stege der Versteifungsmodule abhängig von der Formgebung des Flächenelementes ist.

Bevorzugt ist ein Versteifungssystem ein (versteiftes) Bauteil oder Rohbauteil, insbesondere von Fahrzeugen.

### Detaillierte Beschreibung

### Kurzbeschreibung der Figuren

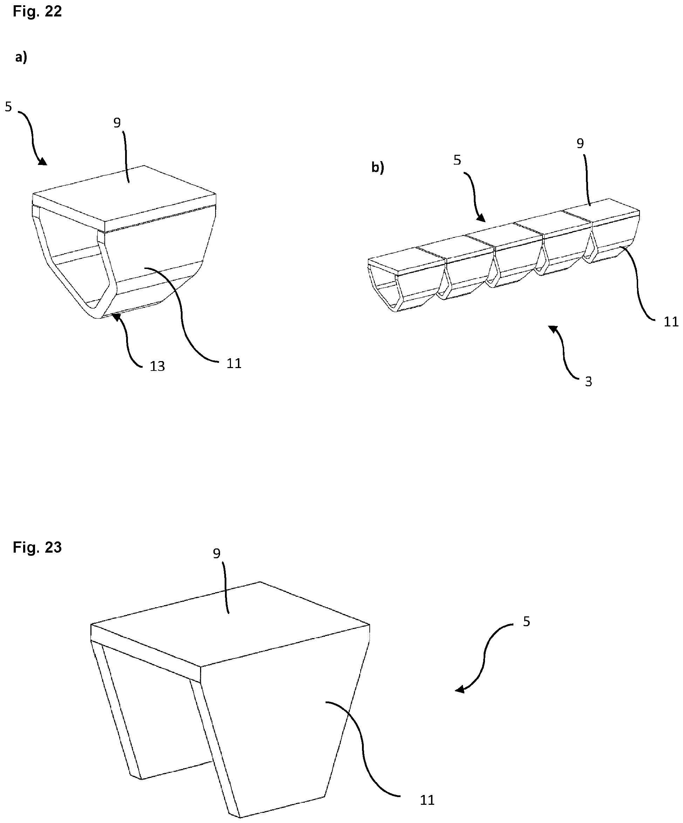

- Fig. 1: Darstellung einer bevorzugten Versteifungsstruktur
- Fig.2: Darstellung eines bevorzugten Versteifungssystems
- Fig.3: Darstellung eines bevorzugten Versteifungsmoduls
- Fig.4: Darstellung einer bevorzugten Versteifungsstruktur, umfassend sieben Versteifungsmodule
- Fig.5: Darstellung eines bevorzugten Versteifungssystems
- Fig.6: Schematische Darstellung bevorzugter Versteifungen aus dem Stand der Technik
- Fig.7: Gegenüberstellung von bevorzugten erfindungsgemäßen Versteifungssystemen und einem Versteifungssystem aus dem Stand der Technik
- Fig. 8: Gegenüberstellung konventioneller Fertigungsverfahrensabläufe für die Herstellung von Versteifungsstrukturen gegenüber einem bevorzugten Verfahren
- Fig.9: a) Bevorzugtes Versteifungssystem auf einem konkav ausgestaltetem Flächenelement
b) Bevorzugtes Versteifungssystem auf einem konvex ausgestaltetem Flächenelement
- Fig. 10: a) Bevorzugtes Versteifungsmodul mit zwei Stegen
b) Bevorzugte Versteifungsstruktur, welche durch die Versteifungsmodule der Fig. 10a) gebildet wird
- Fig. 11: Bevorzugtes Versteifungsmodul mit zwei Stegen und abgerundeten Kanten
- Fig. 12: a) Bevorzugtes Versteifungsmodul mit einem Steg
b) Bevorzugte Versteifungsstruktur umfassend Versteifungsmodule mit einem Steg, wobei die Stege aneinandergereiht vorliegen
c) Bevorzugte Versteifungsstruktur umfassend Versteifungsmodule mit einem Steg, wobei die Stege nebeneinanderliegender Versteifungsmodule gegenüberliegend angeordnet sind
- Fig. 13: a) Bevorzugtes Versteifungsmodul mit einem Steg und abgerundeter Kante
b) Bevorzugte Versteifungsstruktur umfassend Versteifungsmodule mit einem Steg und abgerundeter Kante, wobei die Stege aneinandergereiht vorliegen
c) Bevorzugte Versteifungsstruktur umfassend Versteifungsmodule mit einem Steg und abgerundeter Kante, wobei die Stege nebeneinanderliegender Versteifungsmodule gegenüberliegend angeordnet sind
- Fig. 14: a) Bevorzugtes Versteifungsmodul umfassend einen mittig am Gurt angeordneten Steg
b) Bevorzugte Versteifungsstruktur umfassend Versteifungsmodule mit einem mittig am Gurt angeordneten Steg
- Fig. 15: Bevorzugte Versteifungsstruktur umfassend Versteifungsmodule, wobei die Versteifungsmodule einen abgekanteten Steg aufweisen.

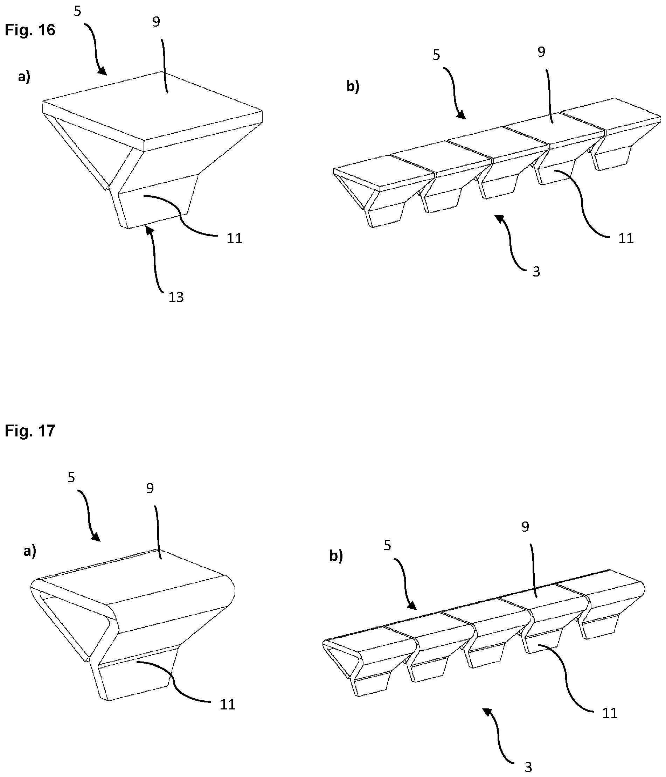

- Fig. 16: a) Bevorzugtes Versteifungsmodul umfassend einen in dreiecksform ausgestalteten Steg
b) Bevorzugte Versteifungsstruktur umfassend Versteifungsmodule mit einen in dreiecksform ausgestalteten Steg
- Fig. 17: a) Bevorzugtes Versteifungsmodul umfassend einen in dreiecksform ausgestalteten Steg mit abgerundeten Kanten
b) Bevorzugte Versteifungsstruktur umfassend Versteifungsmodule mit einen in dreiecksform ausgestalteten Steg und abgerundeten Kanten
- Fig. 18: a) Bevorzugtes Versteifungsmodul umfassend einen bogenförmigen Gurt
b) Bevorzugte Versteifungsstruktur umfassend Versteifungsmodule bogenförmigen Gurten
- Fig. 19: a) Bevorzugtes Versteifungsmodul umfassend einen als offenen Ring ausgestalteten Steg
b) Bevorzugte Versteifungsstruktur umfassend Versteifungsmodule mit als offenen Ring ausgestalteten Stegen
- Fig. 20: a) Bevorzugtes Versteifungsmodul umfassend einen spitz zulaufenden Gurt
b) Bevorzugte Versteifungsstruktur umfassend Versteifungsmodule mit spitz zulaufenden Gurten
- Fig. 21: a) Bevorzugtes Versteifungsmodul umfassend zwei aufeinander zulaufende Stege
b) Bevorzugte Versteifungsstruktur umfassend Versteifungsmodule mit zwei aufeinander zulaufenden Stegen
- Fig. 22: a) Bevorzugtes Versteifungsmodul umfassend zwei aufeinander zulaufende Stege, wobei die Stege in einem unteren Bereich aufeinander zulaufen
b) Bevorzugte Versteifungsstruktur umfassend Versteifungsmodule mit zwei aufeinander zulaufenden Stegen, wobei die Stege in einem unteren Bereich aufeinander zulaufen
- Fig. 23: Bevorzugtes Versteifungsmodul mit zwei im Wesentlichen parallel verlaufenden Stegen

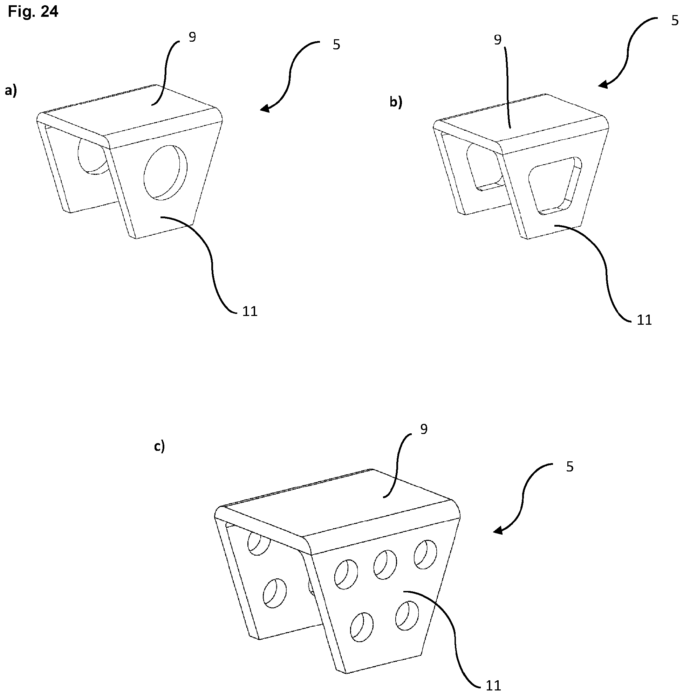

- Fig. 24: a) Bevorzugtes Versteifungsmodul mit zwei im Wesentlichen parallel verlaufenden Stegen, wobei die Stege eine rund ausgestaltete seitliche Öffnung aufweisen
b) Bevorzugtes Versteifungsmodul mit zwei im Wesentlichen parallel verlaufenden Stegen, wobei die Stege eine trapezförmig ausgestaltete seitliche Öffnung aufweisen
c) Bevorzugtes Versteifungsmodul mit zwei im Wesentlichen parallel verlaufenden Stegen, wobei die Stege eine Vielzahl von rund ausgestalteten seitlichen Öffnungen aufweisen
- Fig. 25: a) Bevorzugtes Versteifungsmodul mit zwei im Wesentlichen parallel verlaufenden Stegen, wobei sich die Stege entlang einer Höhe verjüngen
b) Bevorzugtes Versteifungsmodul mit zwei im Wesentlichen parallel verlaufenden Stegen, wobei sich die Stege entlang einer Höhe verjüngen in und die Stege in den Seitenflächen Öffnungen aufweisen
- Fig. 26: Bevorzugte Versteifungsstruktur mit umfassend Versteifungsmodule mit konvex sowie konkaven Gurtstirnseiten

- Fig. 27: Bevorzugte Versteifungsstruktur umfassend Versteifungsmodule mit geradlinig ausgestalteten Gurtstirnseiten

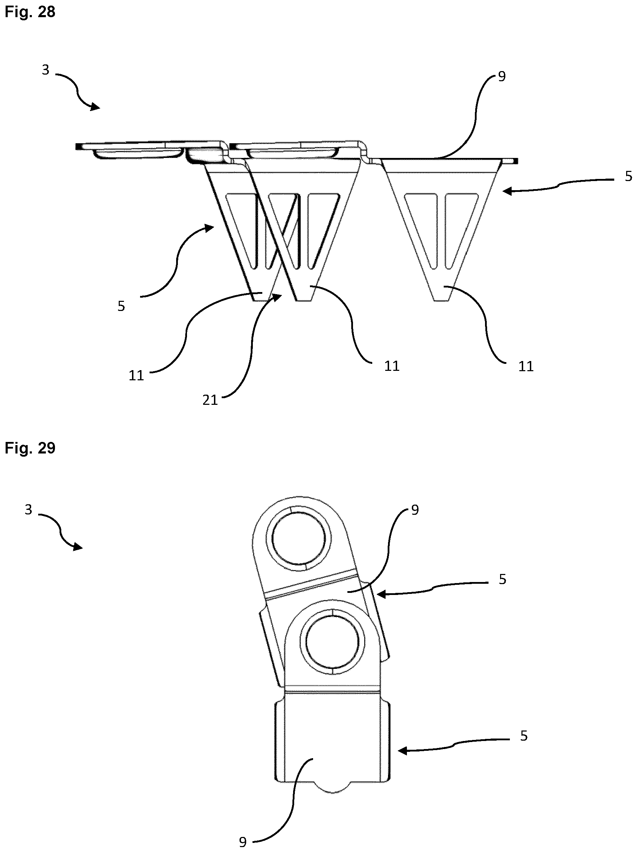

- Fig. 28: Bevorzugte Versteifungsstruktur umfassend Versteifungsmodule mit sich überlappenden Gurten in einer Seitenansicht
- Fig. 29: Bevorzugte Versteifungsstruktur umfassend Versteifungsmodule mit sich überlappenden Gurten in einer Draufsicht

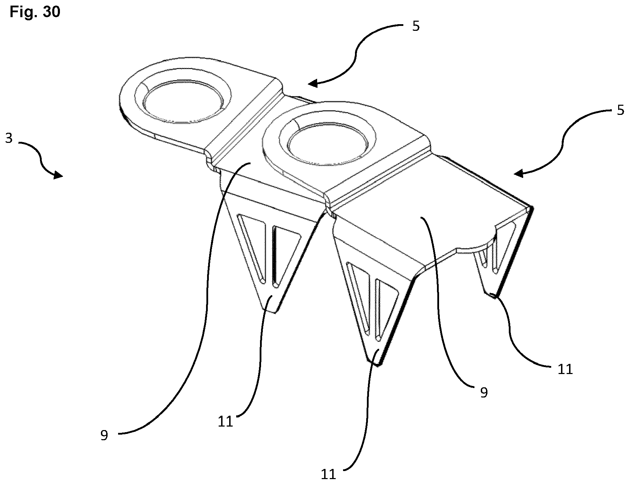

- Fig. 30: Bevorzugte Versteifungsstruktur umfassend Versteifungsmodule mit sich überlappenden Gurten in einer rückwärtigen Schrägansicht

### Detaillierte Beschreibung der Figuren

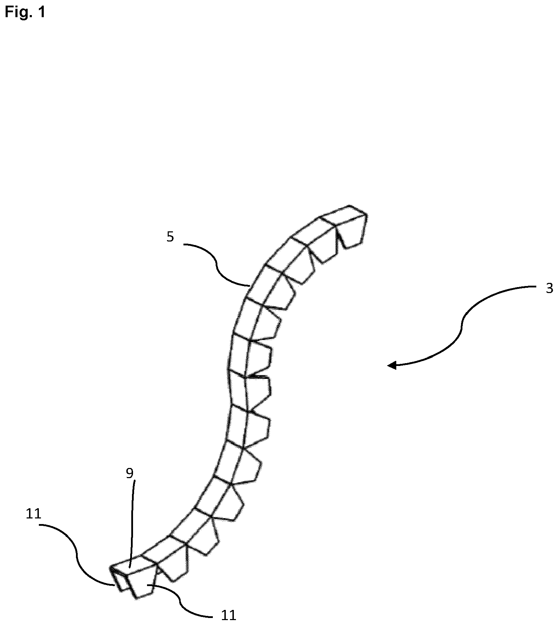

**Fig. 1** illustriert eine bevorzugte Versteifungsstruktur **3** umfassend eine Vielzahl von Versteifungsmodulen **5.** Ein Versteifungsmodul **5** weist dabei einen Gurt **9** und zwei Stege **11** auf, wobei die Stege **11** in der dargestellten Ausführungsform im Wesentlichen parallel zueinander verlaufen. Die einzelnen Versteifungsmodule **5** sind über ihren jeweiligen Gurt **9** formschlüssig, kraftschlüssig und/oder stoffschlüssig miteinander verbunden. Die Verbindung der Gurte **9** generiert die erforderliche Steifigkeit der gesamten Versteifungsstruktur **3.** Darüber hinaus stehen die Stege **11** nebeneinanderliegender Versteigungsmodule **5** nicht in Verbindung miteinander, sodass im Vergleich zu Lösungen aus dem Stand der Technik kein durchgehender Gesamtsteg der Versteifungsstruktur **3** vorliegt. Hierdurch wird eine Materialersparnis erreicht, ohne die Stabilität zu kompromittieren.

**Fig. 2** zeigt ein bevorzugtes Versteifungssystem **1.** Ein Versteifungssystem **1** weist bevorzugt ein Flächenelement **7** und eine Versteifungsstruktur **3** auf. Das bevorzugte Flächenelement 7 ist teilweise konkav und teilweise konvex ausgestaltet. Dementsprechend sind die einzelnen Versteifungsmodule **5** entsprechen angepasst ausgelegt, sodass die Stege **11** der einzelnen Versteifungsmodule **5** innerhalb der Versteifungsstruktur **3** variieren können. Eine formschlüssig, kraftschlüssig und/oder stoffschlüssig Verbindung liegt erfindungsgemäß bevorzugt nur an Gurten **11** der Versteifungsmodule 5 vor. Die Stege **11** sind demgegenüber nicht miteinander verbunden, sodass zwischen den Stegen **11** Freiflächen ausgestaltet sind.

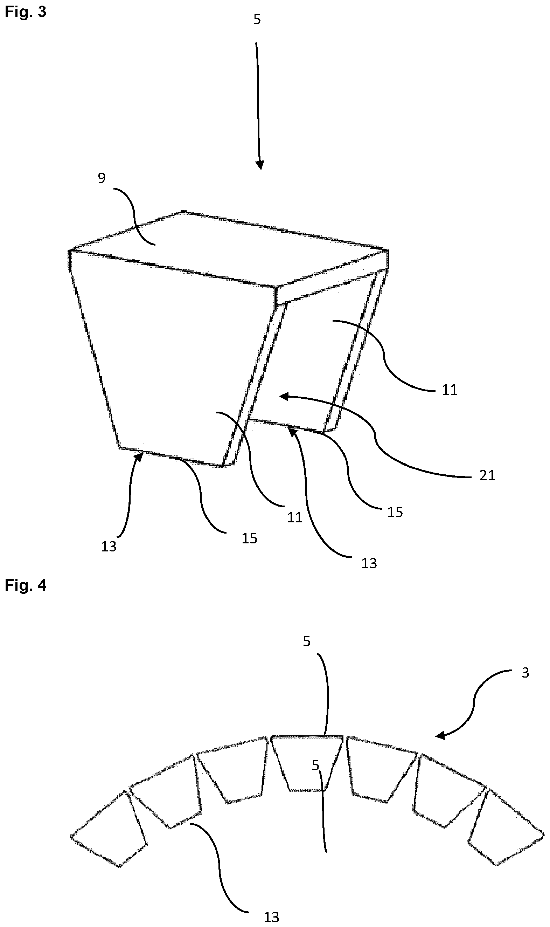

**Fig. 3** zeigt ein bevorzugtes Versteifungsmodul **5**, wobei das Versteifungsmodul **5** zwei Stege **11** umfasst. Die Stege **11** sind voneinander mit einem Spalt **21** voneinander beabstandet und stirnseitig über einen Gurt **9** miteinander verbunden. Die Stege **11** liegen dabei parallel zueinander. Auf der nach unten gerichteten Stirnseite sind die Auflageflächen **13** des Moduls **5** ausgestaltet. Die Auflagefläche **13** und die Stege 11 definieren eine Stegkontaktlinie **15.**

**Fig. 4** ist eine Darstellung einer bevorzugten Versteifungsstruktur **3.** Die Versteifungsstruktur **3** ist schematisch in einer Seitenansicht dargestellt. Die Summe der Stegkontaktlängen, welche die Projektion der Stegkontaktlinien **15** in einer Ebene (hier: Seitenansicht) darstellt, ist dabei kleiner als die Gesamtlänge der Versteifungsstruktur **3** projiziert auf dieselbe Ebene. Dies führt zu der vorteilhaften Bauweise der Versteifungsstruktur, dass Aussparungen oder Freiflächen zwischen den einzelnen Stegen **11** der nebeneinander angeordneten Versteifungsmodule **5.**

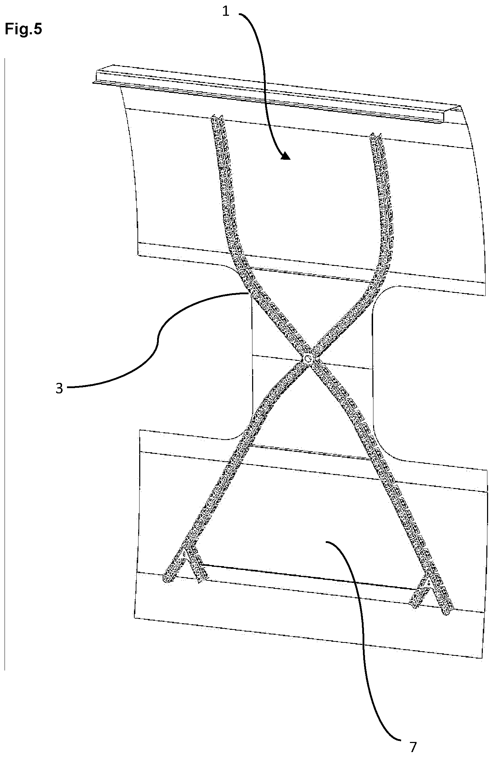

**Fig. 5** ist die Darstellung eines bevorzugten Versteifungssystems **3.** Die bevorzugte Versteifungsstruktur **3** ist in Form eines "geschwungenen X" ist auf einem Großbauteil, bevorzugt einer Schienenfahrzeugseitenwand **7**, zwischen zwei in der Wand **7** angebrachten Fenstern ausgestaltet.

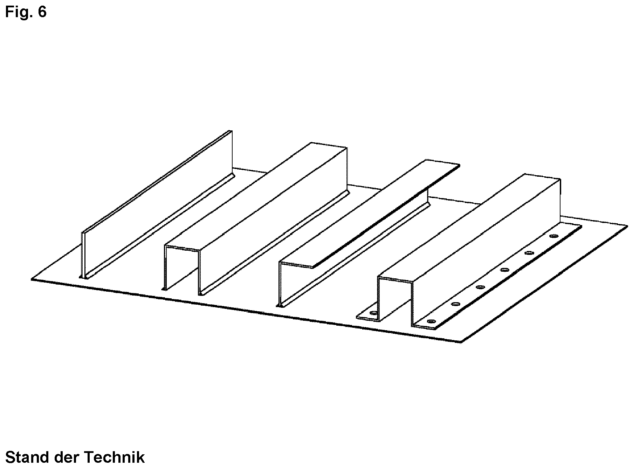

**Fig. 6** ist die Darstellung von herkömmlichen Versteifungsstrukturen aus dem Stand der Technik. Diese sind insbesondere linear bzw. geradlinig ausgestaltet. Es handelt sich hierbei um Profilträger, die einen durchgängigen Gurt sowie einen durchgängigen Steg aufweisen. Die Träger sind im Gegensatz zur erfindungsgemäßen Versteifungsstruktur nicht modular aufgebaut und daher aufgrund ihrer Bauweise auch nur in einer geradlinig ausgestalteten Form herstellbar.

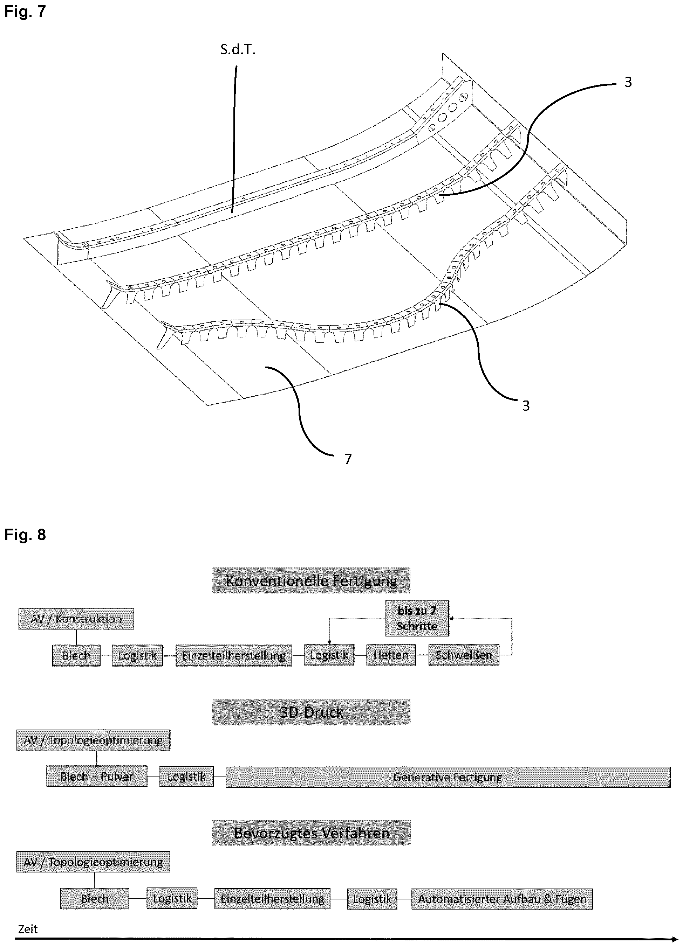

**Fig. 7** zeigt drei verschiedene Versteifungsstrukturen. Eine erste linear bzw. geradlinig ausgestaltete Versteifungsstruktur ist hinlänglich aus dem Stand der Technik bekannt. Darüber hinaus ist eine bevorzugte zweite Versteifungsstruktur **3** linear bzw. geradlinig und eine dritte bevorzugte Versteifungsstruktur **3** nicht linear bzw. nicht geradlinig verlaufend ausgestaltet. Die wesentlichen Unterschiede der Erfindung gegenüber dem Stand der Technik werden in Fig. 7 deutlich. Die Ausgestaltung nicht miteinander verbundener Stege **11** und damit einhergehende Freiflächen zwischen den Stegen **11** führt dazu, dass der Materialaufwand geringgehalten wird. Die modulare Bauweise bzw. die Sequenzierung ermöglicht es hingegen auch nichtgeradlinig ausgestaltete Lastpfade nachzubilden, wodurch topologieoptimierte Versteifungsstrukturen **3** erhalten werden können.

**Fig. 8** illustriert drei Ablaufdiagramme. Hierbei sind die herkömmlichen Verfahren aus dem Stand der Technik "Laserschweißen" sowie "3D-Druck" dem erfindungsgemäßen bevorzugten Verfahren gegenübergestellt.

**Fig.9** ist die Darstellung eines bevorzugten Versteifungssystems 1 in zwei verschiedenen Ausführungsformen. Die **Fig. 9a** stellt dabei ein Versteifungssystem auf einem konkav ausgestalteten Flächenelement **7** dar. **Figur 9b** hingegen ist die Darstellung auf einem konvexen Flächenelement **7.** Beide Ausführungsformen weisen die gleichen Versteifungsmodule **5** auf. Es ist im Sinne der Erfindung möglich, dass ein Flächenelement **7** beide Ausgestaltungen aufweist - konkav und konvex - dies ist beispielsweise in **Fig. 2** dargestellt.

**Fig. 10a** zeigt ein bevorzugtes Versteifungsmodul **5**, welches zwei im Wesentlichen parallel ausgestaltete Stege **11** aufweist und mit einem Spalt **21** beabstandet ist (s. auch **Fig. 3**). Der Gurt **9** ist hingegen im Wesentlichen planar und in einem 90° Winkel zu den beschriebenen Stegen **11** ausgestaltet. **Fig. 10b** illustriert eine bevorzugte Versteifungsstruktur **3** mit fünf aneinandergereihten Versteifungsmodulen aus **Fig. 10a**, wobei ausschließlich die einzelnen Gurte **9** Der einzelnen Versteifungsmodule **5** miteinander verbunden sind und einen durchgängigen Gesamtgurt der Versteifungsstruktur **3** generieren.

**Fig. 11** ist die Darstellung eines bevorzugten Versteifungsmoduls **5**, wobei das Versteifungsmodul **5** zwei im Wesentlichen parallel ausgestaltete Stege **11** aufweist. Die bevorzugte Ausführungsform weist darüber hinaus abgerundete Kanten im Übergang von Gurt **9** zu Steg **11** auf. Die abgerundeten Kanten können auch in weiteren Varianten als abgeschrägte Fasen ausgeprägt sein.

**Fig. 12a** stellt ein bevorzugtes Versteifungsmodul **5** dar. Dieses Versteifungsmodul **5** enthält nur einen Steg **11** und einen Gurt **9.** Der Steg **11** ist dabei einseitig am Gurt **9** angebracht. Die **Figur 12b** bildet darüber hinaus über die Aneinanderreihung der Versteifungsmodule **5** aus **Fig. 12a** eine Versteifungsstruktur **3.** Die Versteifungsmodule **3** sind erfindungsgemäß bevorzugt nur an den Gurten **9** miteinander verbunden. Die in **Fig. 12 b**dargestellte Versteifungsstruktur **3** umfasst nur einseitig aufgeführte Stege **11.** Demgegenüber steht die Figur **12c**, in welcher nebeneinander angereihte Versteifungsmodule **5** die Stege **11** bevorzugt auf einer gegenüberliegenden Seite des jeweils vorhergehenden Versteifungsmoduls **5** aufweisen.

**Fig. 13** illustriert ein bevorzugtes Versteifungsmodul **5** mit einem einseitig aufgeführten Steg **11.** Im Gegensatz zur Ausführungsform der in **Figur 12a****-c** dargestellten Versteifungsmodule **5**, sind die in **Figur 13a** abgebildeten Module **5** im Übergang zwischen Steg **11** und Gurt **9** abgerundet.

Die in **Fig. 13 b** und **c** aufgeführten Ausführungsformen sind analog zur Ausführungsform in **Fig 12a****-c** zu sehen, wobei sich die Versteifungsmodule **5** der jeweiligen Ausführungsformen im Übergang von Steg **11** und Gurt **9** unterscheiden. **Fig. 13 b** und **c** weisen nämlich Versteifungsmodule **5** mit abgerundeten Kanten auf. Weiterhin bevorzugt können die abgerundete Kante auch als abgefräste bzw. abgeschrägte Fasen ausgebildet sein.

Die in **Fig 14** **a** und **b** dargestellten bevorzugten Versteifungsmodule **5** umfassen einen einzelnen Steg **11** und einen Gurt **9.** Das Versteifungsmodul **5** ist dabei bevorzugt aus zwei separaten Halbzeugen gefertigt. So ist der Steg **11** ein Bauteil und der Gurt **9** ein davon unabhängiges Bauteil. Der Gurt **9** und der Steg **11** sind somit zweiteilig ausgeführt und formschlüssig und auch bevorzugt kraftschlüssig (Presspassung) sowie stärker bevorzugt stoffschlüssig miteinander verbunden, wobei der Steg **11** stirnseitig zwei Einsteckfortsätze aufweist, welche in entsprechend bereitgestellter Öffnungen innerhalb des Gurtes **9** eingebracht werden. Bevorzugt handelt es sich hierbei um eine Presspassung, sodass die Verbindung ohne weitere Verbindungsmittel ausreichend stabil ist. Stärker bevorzugt wird die Einsteckverbdingung über ein Laserschweißverfahren stoffschlüssig verbunden. Die in **Fig.14b** dargestellte Versteifungsstruktur 3 weist die in **Fig. 14a** illustrierten zweiteiligen Versteifungsmodule **5** auf.

**Fig. 15** illustriert eine Versteifungsstruktur **3** umfassend Versteifungsmodule **5** mit einseitig ausgestalteten Stegen **11.** Der Gurt **9** der jeweiligen Versteifungsmodule **5** schließt mit dem Steg 11 der jeweiligen Versteifungsmodule **5** bevorzugt einen Winkel >90° ein. Die dargestellte Ausführungsform der Versteifungsstruktur **3** ist bevorzugt ein Teilelement einer Versteifungsstrukturreihe, wobei die weiteren in der Versteifungsstrukturreihe angeordneten Versteifungsstrukturen **3** anderweitige Ausgestaltungen aufweisen können

**Fig. 16a** stellt ein bevorzugtes Versteifungsmodul **5** dar, welches einen Dreieckssteg **11** aufweist. Der Dreiecksteg **11** greift dabei an zwei Seiten des Gurtes **9** an, wobei der Steg **11** von zwei Seiten (Gurtkanten) aufeinander zuläuft und ein Dreieck bildet. In einem unteren Bereich, ist ein Stegabsatz ausgebildet, welcher die Auflagefläche **13** aufweist. Der Dreiecksteg weist in einem Querschnitt abstrahiert die Form des Buchstabens "Y" auf.

Die **Fig. 16b** zeigt eine Versteifungsstruktur **3**, wobei fünf der in **Fig.16a** abgebildeten Versteifungsmodule **5** aneinandergereiht über die jeweiligen Gurte **9** formschlüssig, kraftschlüssig und/oder stoffschlüssig miteinander verbunden sind.

**Fig. 17a** zeigt eine weitere Variante eines bevorzugten Versteifungsmoduls **5** mit einem Absatz versehenden Dreiecksstegs **11.** Im Vergleich zur Ausführungsform aus **Fig. 16a** und **b** sind die Kanten im Übergang von Gurt **9** zu Steg **11** jedoch abgerundet. Weiterhin bevorzugt können die abgerundete Kante auch als abgefräste bzw. abgeschrägte Fasen ausgebildet sein.

**Fig. 17b** illustriert eine bevorzugte Versteifungsstruktur **3** mit den in **Fig. 17a** aufweisenden Versteifungsmodulen **5.**

**Fig. 18a** zeigt eine weitere Ausführungsform eines bevorzugte Versteifungsmoduls **5.** In der abgebildeten Variante ist der Gurt **9** als ein Bogen ausgestaltet, wohingegen das Versteifungsmodul **5** weiterhin zwei Stege **11** aufweist welche durch einen Spalt 21 voneinander beabstandet sind. Die Stege **11** verlaufen im Wesentlichen parallel zueinander.

In **Fig. 18b** illustriert fünf Versteifungsmodule **5** der Ausführungsform nach **Fig. 18a**, welche zu einer Versteifungsstruktur **5** aneinandergereiht sind.

Das in **Fig. 19a** dargestellte Versteifungsmodul **5** weist einen Gurt **9** und einen wirbelkörperförmigen Steg **11** auf. Die dargestellte Ausführungsform ist in Anlehnung an eine Wirbelsäule des Menschen ausgestaltet. So ist der Steg **1**1 in seinem Querschnitt in C-Form ausgestaltelt, wobei die offene Seite des, C's am Gurt **9** befestigt ist. Der Steg **11** kann bevorzugt auch als offener Ring beschrieben werden, wobei die Öffnung des Rings mit einem horizontal liegenden Gurt **9** abgedeckt wird.

**Fig. 19b** illustriert eine bevorzugte Ausführungsform einer Versteifungsstruktur **3**, wobei das in **Fig. 19a** abgebildete Versteifungsmodul **5** ist fünffach aneinandergereiht ist. Die dargestellte Versteifungsstruktur **3** ist insbesondere der Wirbelsäule eines Menschen nachempfunden. So wirken die Stege **11** in Ihrer Ausgestaltung wie Wirbelkörper der Wirbelsäule.

**Fig. 20a** zeigt ein bevorzugtes Versteifungsmodul **5** mit zwei zueinander im Wesentlichen parallel liegenden Stegen 11. Beide Stege **11** sind über einen Gurt **9** miteinander verbunden. Diese spezielle Ausgestaltung weist jedoch bevorzugt einen Gurt **9** mit zwei aufeinander zu laufenden Flächen (Dachflächen) auf. Weiterhin sind die Kanten des Versteifungsmoduls **5** bevorzugt durch Fasen abgeschrägt.

In Fig. **20b** ist eine bevorzugte Versteifungsstruktur **3** abgebildet. Diese Versteifungsstruktur **3** weist fünf über ihre Gurte **9** miteinander verbundene Versteifungsmodule **5** aus **Fig. 20a** auf.

**Fig. 21a** ist die Darstellung eines bevorzugten Versteifungsmoduls **5.** Ähnlich wie schon das in **Fig. 17a** abgebildete Versteifungsmodul weist das in **Fig. 21a** dargestellte Versteifungsmodul **5** einen Dreiecksteg **11** auf. Dabei laufen ausgehend von zwei Gurtkanten zwei Flächen aufeinander zu und bilden ein Dreieck., Die Dreieckspitze ist durch eine Fase abgeflacht, und dient als Auflagefläche **13** des Versteifungsmoduls **5.**

**Fig. 21b** illustriert eine bevorzugte Versteifungsstruktur **3**, Die Versteifungsstruktur **3** umfasst fünf Versteifungsmodule **5** der Ausgestaltung nach **Fig. 21a****.**

In **Fig. 22a** **ist** eine weitere bevorzugte Ausführungsform eines Versteifungsmoduls **5** dargestellt. Der im Versteifungsmodul **5** umfasste Steg 11 weist ausgehend von zwei Gurtkanten zwei im Wesentlichen parallel ausgestaltete Flächen auf, wobei diese Flächen in einem unteren Bereich des Versteifungsmoduls 5 eine Richtungsänderung annehmen und aufeinander zulaufen, sodass sie eine gemeinsame Auflagefläche **13** bilden.

**Fig. 22b** illustriert eine bevorzugte Versteifungsstruktur **3**, Die Versteifungsstruktur **3** umfasst fünf Versteifungsmodule **5** der Ausgestaltung nach **Fig. 22a****.**

**Fig. 23** illustriert ein bevorzugtes Versteifungsmodul **5.** Dieses Versteifungsmodul ist ebenfalls in **Fig. 3** und **Fig. 10a** abgebildet und dient als Ausgangspunkt der nachfolgenden **Figuren 24a****-c.**

Die in **Fig. 24a****-c** abgebildeten Versteifungsmodule **5** basieren auf dem vorhergehenden Versteifungsmodul **5**, illustriert in **Fig. 23****.** Die dargestellten Versteifungsmodule **5** weisen jedoch in den Stegen **11** Öffnungen bzw. Aussparungen oder Durchbrüche auf. Dies ermöglicht eine weitere erhöhte Materialersparnis in Bezug auf eine Versteifungsstruktur **3** und/oder einem Versteifungssystem **1.** Diese können jegliche Form annehmen (bspw. rund, **Fig. 24a** und **Fig. 24c** und/oder trapezförmig, **Fig. 24b**). Es sind jedoch auch jegliche Polygone möglich. Darüber hinaus können ebenfalls eine Vielzahl von Öffnungen in einem Steg **11** umfasst sein.

**Fig. 25a** zeigt ein bevorzugtes Versteifungsmodul **5** mit zwei im Wesentlichen parallel zueinander verlaufenden Stegen **11**, wobei sich die Stege **11** sich entlang ihrer Höhe verjüngen. Darüber hinaus weise die Gurtkanten eine Fase auf.

**Fig. 25b** illustriert ein weiteres bevorzugtes Versteifungsmodul **5** mit zwei im Wesentlichen parallel verlaufenden Stegen **11**, wobei sich die Stege **11** sich entlang ihrer Höhe verjüngen und die Stege **11** in den Seitenflächen Öffnungen aufweisen.

In **Fig. 26** ist eine bevorzugte Versteifungsstruktur **3** umfassend fünf Versteifungsmodule **5** dargestellt. Die Versteifungsmodule **5** weisen dabei jeweils zwei im Wesentlichen parallel zueinander verlaufende Stege **11** auf. Darüber hinaus sind diese durch einen Gurt **9** miteinander verbunden, Der Gurt **9** weist dabei eine konvexe sowie konkave Stirnseite auf.

**Fig. 27** zeigt eine weitere bevorzugte Versteifungsstruktur **3** mit fünf Versteifungsmodulen **5.** Die Versteifungsmodule **5** sind über ihrer Gurte **9** miteinander aneinandergereiht verbunden. Die Gurte **9** weisen dabei geradlinig ausgestalteten Gurtstirnseiten auf. Die Gurtflächen der Gurte **9** sind trapezförmig gestaltet.

**Fig. 28** zeigt eine weitere bevorzugte Versteifungsstruktur **3** mit zwei Versteifungsmodulen **5** von einer Seitenansicht. Die Versteifungsmodule **5** weisen vorzugsweise jeweils einen Gurt **9** und zwei Stege **11** auf, wobei die Stege **11** in einem Spalt **21** voneinander beabstandet und im Wesentlichen parallel zueinander ausgerichtet sind. Der Gurt **9** ist hingegen bevorzugt zweiteilig ausgestaltet: Ein erstes Teilelement dient bevorzugt als eine Überlappungsfläche, wohingegen ein zweites Teilelement bevorzugt als eine Basisfläche dient. Die Basisfläche verbindet bevorzugt die beiden Stege **11** miteinander und ist entsprechend als ein Brückenelement anzusehen. Ausgehend von der Basisfläche weist der Gurt **9** einen Fortsatz auf, welcher bevorzugt die Überlappungsfläche definiert. Die Überlappungsfläche bzw. der Fortsatz liegt bevorzugt über einen Absatz in der Höhe von der Basisfläche versetzt vor. Die Versteifungsmodule **5** sind ferner über ihre Gurte **9** miteinander aneinandergereiht verbunden, wobei die Basisfläche eines vorhergehenden Versteifungsmoduls **5** sich mit der Überlappungsfläche eine nachfolgenden Versteifungsmoduls **5** überlappt bzw. überschneidet. In anderen Worten liegt die Überlappungsfläche eines zweiten Versteifungsmoduls **5** bevorzugt auf der Basisfläche eines ersten Versteifungsmoduls **5** auf. Über Laserstrahlschweißen, Widerstandspunktschweißen oder andere Fügeverfahren werden die beiden Flächen bevozugt stoffschlüssig miteinander verbunden. Die Stege **11** weisen darüber hinaus bevorzugt Aussparungen bzw. Öffnungen auf, was insbesondere zu einem Gewichtsersparnis führt. Zudem verjüngen sich die Stege **11** ausgehend vom Gurt **9** in Richtung einer Auflagefläche.

Fig. 29 und Fig. 30 zeige eine bevorzugte Versteifungsstruktur **3** umfassend Versteifungsmodule **5** mit sich überlappenden Gurten **9** in einer Draufsicht (Fig. 29) sowie in einer rückwärtigen Schrägansicht (Fig. 30). Die in beiden Figuren dargestellten bevorzugten Ausführungsformen entsprechen der schon in Fig. 28 beschriebenen Ausführungsform und zeigen diese in zwei weiteren Perspektiven.

### Bezugszeichenliste

- 1: Versteifungssystem
- 3: Versteifungsstruktur
- 5: Versteifungsmodul
- 7: Flächenelement
- 9: Gurt
- 11: Steg
- 13: Auflagefläche
- 15: Stegkontaktlinie
- 21: Spalt

### Literaturverzeichnis

[1] P. Sommer, Biologisch inspirierte Flächenversteifungen nach dem Vorbild der Diatomeen, Bremerhaven: Bachelorarbeit, 2014.
[2] Wirtschaftsvereinigung Stahl, "Fakten zur Stahlindustrie in Deutschland 2017," Düsseldorf, 2018.
[3] J. Nickel, F. Fischer, M. Friedrich, C. Hühne, H. Köke, J. König, G. Kopp und J. Wolff, Projektstudie: Einsatz von CFK-Leichtbau-Faserverbund-Technologien im Schienenfahrzeugbau, Meinders & Elstermann, 2016.
[4] Bahnindustrie.info, "Leichtbau: Weniger Gewicht, weniger Verbrauch," 01 2018. [Online]. Available: https://bahnindustrie.info/de/positionen/vdb_politikbriefe/detail/leichtbau weniger _gewicht_weniger_verbrauch/. [Zugriff am 29 04 20].
[5] Ingenieur.de, "Aluminium erlaubt Leichtbauinnovationen," 09 2010. [Online]. Available: https://www.ingenieur.de/technik/fachbereiche/werkstoffe/aluminiumerlaubt-leichtbauinnovationen/. [Zugriff am 29 04 20].
[6] T. Keilig und A. Schmidt, "Gewichtsprognose von CFK-Rümpfen für zukünftige Passagierflugzeuge," in Deutscher Luft- und Raumfahrtkongress, 2002.
[7] F. f. E. mbH, "CO2-Verminderung_in_der_Primäraluminiumherstellung," 2018.
[8] Bundesministerium für Wirtschaft und Energie, "Leichtbau," [Online]. Available: https://www.bmwi.de/Redaktion/DE/Dossier/leichtbau.html. [Zugriff am 2904 20].
[9] J. Graichen, S. Gores und A. Herold, "Überarbeitung des Emissionsinventars des Flugverkehrs," Umweltbundesamt, Dessau Roßlau, 2010. Berechnung: 5333kg / 100kg x 10.000l x 25a x 0,8kg/l x 3,15kgCO2/kg

## Patentansprüche

1. Verfahren für die Versteifung eines Flächenelementes (7)
umfassend:
- Bereitstellung von Versteifungsmodulen (5) umfassend einen Gurt (9) und einen Steg (11)
- aneinandergereihte Anbringung der Versteifungsmodule (5) entlang eines Lastpfades an dem Flächenelement (7), wobei die Versteifungsmodule (5) über Verbindungsmittel und/oder Fügeverfahren formschlüssig, kraftschlüssig und/oder stoffschlüssig an den jeweiligen Gurten (9) miteinander zu einer Versteifungsstruktur (3) verbunden werden, sodass die Versteifungsmodule (5) eine gemeinsame Wirkung, nämlich die Versteifung und Verstärkung des Flächenelementes (7) entlang des Lastpfades entfalten
wobei der Lastpfad für das Flächenelement (7) topologieoptimiert anhand einer belastungsoptimierten Simulation und/oder Berechnung erhalten wurde und wobei der Lastpfad nicht geradlinig ist.

2. Verfahren nach Anspruch 1
**dadurch gekennzeichnet, dass**
die Stege (11) der Versteifungsmodule (5) mit dem Flächenelement (7) Kontaktlinien bilden, wobei die Kontaktlinien der Stege (11) entlang einer Versteifungsstruktur (3) keine durchgängig ausgestaltete Linie darstellen.

3. Verfahren nach Anspruch 1 und/oder 2
**dadurch gekennzeichnet, dass**
die Kontaktlänge der Stege (11) mit dem Flächenelement (7) entlang eines Lastpfades kleiner ist als die Gesamtlänge der Versteifungsstruktur (3).

4. Verfahren nach einem oder mehreren der vorhergehenden Ansprüche
**dadurch gekennzeichnet, dass**
folgende Schritte umfasst sind:
- Bestimmung eines Lastpfades auf einem Flächenelement (7) auf Basis von Berechnungen und/oder Simulationen
- Konstruktion eines Versteifungsmodells entlang des Lastpfades
- Sequenzierung des Versteifungsmodells entlang des Lastpfades in modulare Einheiten
- Konstruktion und Fertigung der Versteifungsmodule (5) anhand durch die Sequenzierung erhaltenen modularen Einheiten.

5. Verfahren nach einem oder mehreren der vorhergehenden Ansprüche
**dadurch gekennzeichnet, dass**
die Stege (11) der Versteifungsmodule (5) Auflageflächen (13) aufweisen und die Versteifungsmodule (5) an den Auflageflächen (13) am Flächenelement (7) angebracht werden.

6. Verfahren nach einem oder mehreren der vorhergehenden Ansprüche
**dadurch gekennzeichnet, dass**
die Fertigung der Versteifungsmodule (5) durch Trennverfahren, bevorzugt Laserschneiden Stanzen und/oder Umformverfahren, bevorzugt Kanten, Pressen und/oder Biegen, erfolgt, wobei der Steg (11) und der Gurt (9) eines Versteifungsmoduls
(i) aus jeweils separaten Halbzeugen gefertigt werden, sodass der Steg (11) und der Gurt (9) miteinander verbunden werden oder;
(ii) aus einem identischen Halbzeug mittels Umformverfahren gefertigt werden.

7. Verfahren nach einem oder mehreren der vorhergehenden Ansprüche
**dadurch gekennzeichnet, dass**
die Versteifungsmodule (5) durch Fügeverfahren miteinander verbunden werden ausgesucht aus der Gruppe umfassend: Schweißen, bevorzugt Laserstrahlschweißen, Lichtbogenschweißen, Elektronenstrahlschweißen und/oder Widerstandspunktschweißen sowie Löten, Schrauben, Nieten, Kleben.

8. Verfahren nach einem oder mehreren der vorhergehenden Ansprüche
**dadurch gekennzeichnet, dass**
- das Flächenelement (7) ein zu versteifendes Bauteil, bevorzugt Rohbauteil, eines Fahrzeuges, bevorzugt ausgewählt aus einer Gruppe umfassend Schienenfahrzeug, Flugzeug oder Schiff
- das Flächenelement (7) ein zu versteifendes Bauteil ist, welches Abmaße von mehr als einem Meter aufweist und/oder
- das Verfahren in der Rohbaufertigung von Fahrzeugen, insbesondere zur Versteifung tragender Rohbauteile, Anwendung findet.

9. Versteifungssystem (1) umfassend eine Versteifungsstruktur (3) und ein Flächenelement (7), wobei die Versteifungsstruktur (3) mindestens zwei Versteifungsmodule (5) umfasst, wobei
die Versteifungsmodule (5) einen Gurt (9) und einen Steg (11) umfassen und so aneinandergereiht und wirkverbunden an dem Flächenelement (7) angebracht vorliegen, dass diese Versteifungsmodule entlang eines für das Flächenelement (7) anhand einer belastungsoptimierten Simulation und/oder Berechnungen erhaltenen, topologieoptimierten nicht geradlinigen Lastpfads vorliegen,
wobei die Versteifungsmodule (5) über Verbindungsmittel und/oder Fügeverfahren formschlüssig, kraftschlüssig und/oder stoffschlüssig an den jeweiligen Gurten (9) miteinander verbunden vorliegen, sodass die Versteifungsmodule (5) eine gemeinsame Wirkung entfalten.

10. Versteifungssystem (3) nach Anspruch 9
**dadurch gekennzeichnet, dass**
der Gurt (9) oder Steg (11) des Versteifungsmoduls (5) aus einem Material ausgestaltet ist ausgewählt aus der Gruppe umfassend Verbundstoff, Stahl, Titan, Nichteisenmetall, bevorzugt Aluminium, Kupfer, Nickel, Blei oder Magnesium, und Kunststoff.

11. Versteifungssystem (1) nach Anspruch 9 oder 10
**dadurch gekennzeichnet, dass**
die Versteifungsmodule (5) der Versteifungsstruktur (3) Auflageflächen (13) aufweisen und über die Auflagenflächen (13) am Flächenelement (7) angebracht sind.

12. Versteifungssystem (1) nach einem der Ansprüche 9-11
**dadurch gekennzeichnet, dass**
die geometrische Ausgestaltung der Stege (9) der Versteifungsmodule (5) abhängig von der Formgebung des Flächenelementes (7) ist.

## Claims

1. Method for stiffening a sheet element (7)
comprising:
- provision of stiffening modules (5) comprising a flange (9) and a web (11)
- attaching the stiffening modules (5) sequentially along a load path on the sheet element (7), wherein the stiffening modules (5) are connected via their respective flanges (9) using connecting means and/or joining methods for a positive, frictional and/or materially bonded connection to form a stiffening structure (3), such that the stiffening modules (5) have a combined effect, specifically stiffening and reinforcing the sheet element (7) along the load path
wherein the load path for the sheet element (7) has been determined in a topology-optimized manner on the basis of a stress-optimized simulation and/or calculation, and wherein the load path is not rectilinear.

2. Method according to claim 1
**characterized in that**
the webs (11) of the stiffening modules (5) form contact lines with the sheet element (7), the contact lines of the webs (11) along a stiffening structure (3) not being a continuous line.

3. Method according to claim 1 and/or 2
**characterized in that**
the contact length of the webs (11) with the sheet element (7) along a load path is shorter than the total length of the stiffening structure (3).

4. Method according to one or more of the preceding claims
**characterized in that**
the following steps are comprised:
- Determination of a load path on a sheet element (7) based on calculations and/or simulations
- Design of a stiffening model along the load path
- Sequencing of the stiffening model along the load path into modular units
- Design and manufacture of the stiffening modules (5) on the basis of modular units determined by said sequencing.

5. Method according to one or more of the preceding claims
**characterized in that**
the webs (11) of the stiffening modules (5) have contact surfaces (13) and the stiffening modules (5) are attached to the contact surfaces (13) on the sheet element (7).

6. Method according to one or more of the preceding claims
**characterized in that**
the stiffening modules (5) are manufactured by separation processes, preferably laser cutting, punching and/or forming processes, preferably edging, pressing and/or bending, wherein the web (11) and the flange (9) of a stiffening module
(i) are respectively manufactured from separate semi-finished products, such that the web (11) and the flange (9) can be joined together or;
(ii) are manufactured from an identical semi-finished product by means of a forming process.

7. Method according to one or more of the preceding claims
**characterized in that**
the stiffening modules (5) are joined together by joining processes selected from the group comprising: welding, preferably laser beam welding, arc welding, electron beam welding and/or resistance spot welding as well as soldering, screwing, riveting, gluing.

8. Method according to one or more of the preceding claims
**characterized in that**
- the sheet element (7) is a component to be stiffened, preferably a body component, of a vehicle, preferably selected from a group comprising a railway vehicle, an aircraft or a ship
- the sheet element (7) is a component to be stiffened which has dimensions of more than one meter and/or
- the process is used in the body production of vehicles, in particular for the stiffening of load-bearing body components.

9. Stiffening system (1) comprising a stiffening structure (3) and a sheet element (7), wherein the stiffening structure (3) comprises at least two stiffening modules (5), wherein
- the stiffening modules (5) comprise a flange (9) and a web (11) and are sequentially connected to one another and functionally connected with the sheet element (7), such that the stiffening modules (5) are positioned along a non-rectilinear load path for the sheet element (7), which has been determined in a topology-optimized manner on the basis of a stress-optimized simulation and/or calculations,
wherein the stiffening modules (5) are connected to one another via their respective flanges by means of connecting means and/or joining methods for a positive, frictional and/or materially bonded connection, such that the stiffening modules (5) have a combined effect.

10. Stiffening system (3) according to claim 9
**characterized in that**
the flange (9) or web (11) of the stiffening module (5) is made of a material selected from the group comprising composite, steel, titanium, non-ferrous metal, preferably aluminum, copper, nickel, lead or magnesium, and plastic.

11. Stiffening system (1) according to claim 9 or 10
**characterized in that**
- the stiffening modules (5) of the stiffening structure (3) have contact surfaces (13) and are attached to the sheet element (7) via the contact surfaces (13).

12. Stiffening system (1) according to claim 9-11
**characterized in that**
the geometric design of the webs (11) of the stiffening modules (5) is dependent on the shape of the sheet element (7).

## Revendications

1. Procédé de renfort d'un élément plat (7)
comprenant :
- la fourniture de modules de renfort (5) comprenant une courroie (9) et une âme (11),
- la fixation alignée des modules de renfort (5) le long d'un trajet de charge sur l'élément plat (7), dans lequel les modules de renfort (5) sont reliés les uns aux autres par complémentarité de forme, par force et/ou par liaison de matière au niveau des courroies respectives (9) via des moyens de raccordement et/ou des procédés d'assemblage pour former une structure de renfort (3), de sorte que les modules de renfort (5) développent un effet commun, à savoir le renfort et le renforcement de l'élément plat (7) le long du trajet de charge,
dans lequel le trajet de charge pour l'élément plat (7) a été obtenu d'une manière optimisée pour la topologie à l'aide d'une simulation et/ou d'un calcul optimisés pour la charge et dans lequel le trajet de charge n'est pas rectiligne.

2. Procédé selon la revendication 1,
**caractérisé en ce que**
les âmes (11) des modules de renfort (5) forment des lignes de contact avec l'élément plat (7), dans lequel les lignes de contact des âmes (11) le long d'une structure de renfort (3) ne constituent pas une ligne continue.

3. Procédé selon la revendication 1 et/ou 2
**caractérisé en ce que**
la longueur de contact des âmes (11) avec l'élément plat (7) le long d'un trajet de charge est inférieure à la longueur totale de la structure de renfort (3).

4. Procédé selon une ou plusieurs des revendications précédentes,
**caractérisé en ce que**
les étapes suivantes sont comprises :
- détermination d'un trajet de charge sur un élément plat (7) sur la base de calculs et/ou de simulations,
- conception d'un modèle de renfort le long du trajet de charge,
- séquençage du modèle de renfort le long du trajet de charge en unités modulaires,
- conception et fabrication des modules de renfort (5) à partir d'unités modulaires obtenues par séquençage.

5. Procédé selon une ou plusieurs des revendications précédentes
**caractérisé en ce que**
les âmes (11) des modules de renfort (5) présentent des surfaces d'appui (13) et les modules de renfort (5) sont fixés à l'élément plat (7) au niveau de surfaces d'appui (13).

6. Procédé selon une ou plusieurs des revendications précédentes
**caractérisé en ce que**
les modules de renfort (5) sont fabriqués par des procédés de découpe, de préférence des procédés de découpe au laser, des procédés d'estampage et/ou de formage, de préférence de délignage, de pressage et/ou de pliage, dans lequel l'âme (11) et la courroie (9) d'un module de renfort
(i) sont fabriquées à partir de produits semi-finis séparés de sorte que l'âme (11) et la courroie (9) sont reliées l'une à l'autre ou ;
(ii) sont fabriquées à partir d'un produit semi-fini identique à l'aide d'un procédé de formage.

7. Procédé selon une ou plusieurs des revendications précédentes
**caractérisé en ce que**
les modules de renfort (5) sont reliés les uns aux autres par des procédés d'assemblage choisis dans le groupe comprenant : le soudage, de préférence le soudage par faisceau laser, le soudage à l'arc, le soudage par faisceau d'électrons et/ou le soudage par résistance par points, et le brasage, le vissage, le rivetage, le collage.

8. Procédé selon une ou plusieurs des revendications précédentes
**caractérisé en ce que**
- l'élément plat (7) est un composant à renforcer, de préférence un élément de coque d'un véhicule, de préférence choisi dans un groupe comprenant un véhicule ferroviaire, un aéronef ou un navire,
- l'élément plat (7) est un composant à renforcer qui a des dimensions supérieures à un mètre, et/ou
- le procédé est utilisé dans la fabrication de coques de véhicules, en particulier pour renforcer les éléments porteurs de la coque.

9. Système de renfort (1) comprenant une structure de renfort (3) et un élément plat (7), dans lequel la structure de renfort (3) comprend au moins deux modules de renfort (5), dans lequel les modules de renfort (5) comprennent une courroie (9) et une âme (11) et sont fixés de manière alignée et reliés fonctionnellement à l'élément plat (7) de sorte que ces modules de renfort sont disposés le long d'un trajet de charge non rectiligne, optimisé pour la topologie et obtenu à l'aide d'une simulation et/ou de calculs optimisés pour la charge pour l'élément plat (7),
dans lequel les modules de renfort (5) sont reliés les uns aux autres par complémentarité de forme, par force et/ou par liaison de matière au niveau des courroies respectives (9) via des moyens de raccordement et/ou des procédés d'assemblage, de sorte que les modules de renfort (5) développent un effet commun.

10. Système de renfort (3) selon la revendication 9,
**caractérisé en ce que**
la courroie (9) ou l'âme (11) du module de renfort (5) est réalisée en un matériau choisi dans le groupe comprenant le composite, l'acier, le titane, les métaux non ferreux, de préférence l'aluminium, le cuivre, le nickel, le plomb ou le magnésium, et le plastique.

11. Système de renfort (1) selon la revendication 9 ou 10 **caractérisé en ce que**
les modules de renfort (5) de la structure de renfort (3) présentent des surfaces d'appui (13) et sont fixés à l'élément plat (7) au niveau des surfaces d'appui (13).

12. Système de renfort (1) selon l'une des revendications 9 à 11
**caractérisé en ce que**
la configuration géométrique des âmes (9) des modules de renfort (5) dépend de la forme de l'élément plat (7).
